# EUROPEAN PATENT APPLICATION

(11) **EP 4 531 501 A1**
(43) Date of publication of application: **02.04.2025**
(21) Application number: 23811751.9
(22) Date of filing: 19.05.2023
(51) Int. Cl.: H05K 1/14, G02F 1/13, G02F 1/1334, G02F 1/1343, G02F 1/1345, H05K 1/02, H05K 1/03

(54) **FLEXIBLE WIRING BOARD UNIT AND DIMMER UNIT**

(30) Priority: 23.05.2022 JP 2022083618; 23.05.2022 JP 2022083619; 23.05.2022 JP 2022083620
(71) Applicant: Toppan Holdings Inc., Tokyo 110-0016 (JP)
(72) Inventor: TSUJI, Masaki, Tokyo 110-0016 (JP); SATO, Hideshi, Tokyo 110-0016 (JP); NAKAMURA, Gen, Tokyo 110-0016 (JP)
(74) Representative: TBK
(86) International application number: PCT/JP2023/018710
(87) International publication number: WO 2023/228879

(57) **Abstract**

A flexible wiring board unit includes: a first flexible wiring board extending in a first direction; and a second flexible wiring board extending in a second direction, wherein the second flexible wiring board is configured to be electrically connected to the first flexible wiring board on a first side of the second flexible wiring board in the second direction, the first direction and the second direction mutually intersecting, the first flexible wiring board includes a first bonding terminal and a second bonding terminal arranged in the first direction, the first bonding terminal and the second bonding terminal are configured to be connected to a power supply target, the second flexible wiring board includes a first power supply terminal and a second power supply terminal disposed on a second side which is opposite to the first side in the second direction, and the first power supply terminal and the second power supply terminal are configured to be connected to an external power supply.

## Description

### [Technical Field]

The present disclosure relates to a flexible wiring board unit including a plurality of electrically connectable flexible wiring boards, and a light control unit including the flexible wiring board unit.

### [Background Art]

A light control sheet includes two transparent electrode sheets and a light control layer disposed between the two transparent electrode sheets. The respective transparent electrode sheets include an electrode terminal. The electrode terminal is a portion of each transparent electrode sheet exposed from the light control layer and the other transparent electrode sheet. The electrode terminals included in the respective transparent electrode sheets are disposed at an edge of the light control sheet. Each of the electrode terminals is bonded to respective bonding terminals included in a flexible wiring board (see e.g., PTLs 1 and 2). As a voltage is applied across the two transparent electrode sheets via the flexible wiring board, the light control sheet changes light transmittance of the light control layer from that before the voltage is applied.

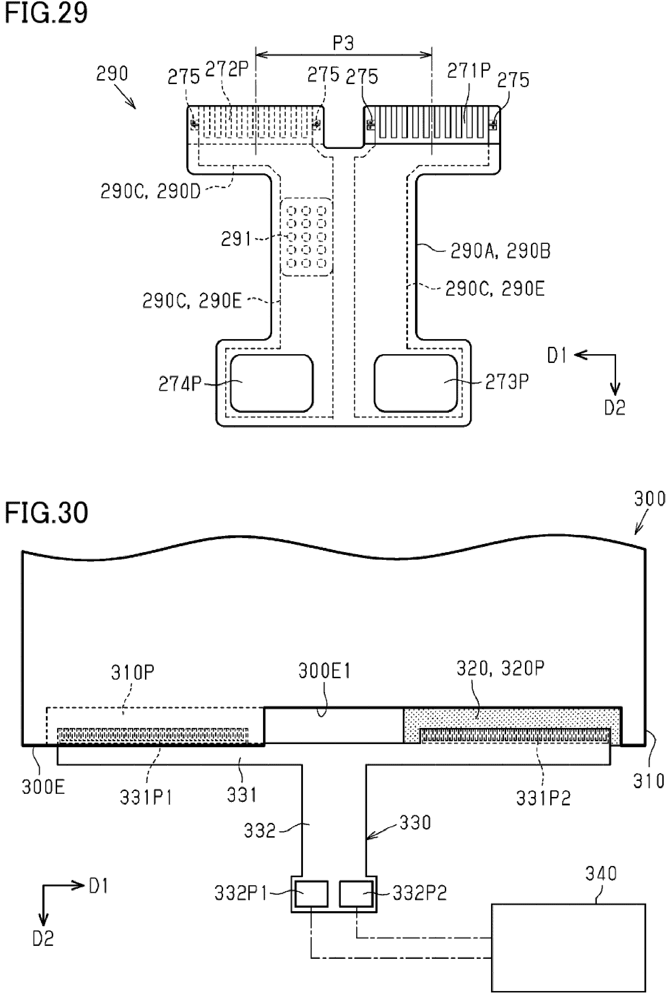

For example, as shown in Fig. 30, a light control sheet 300 includes a first transparent electrode sheet 310, a second transparent electrode sheet 320, and a light control layer disposed between the first transparent electrode sheet 310 and the second transparent electrode sheet 320. In Fig. 30, the first transparent electrode sheet 310 is located on a side of the second transparent electrode sheet 320 facing the front side of the paper. Further, in Fig. 30, for convenience of description of the shape of the respective sheets, the first transparent electrode sheet 310 is indicated by the bold line and the second transparent electrode sheet 320 is indicated by the thin line.

The first transparent electrode sheet 310 includes the first terminal 310P. The first terminal 310P, indicated by the dotted line in Fig. 30, is a portion of the first transparent electrode sheet 310 exposed from the second transparent electrode sheet 320 and the light control layer. The first terminal 310P faces toward the rear side of the paper in Fig. 30. The second transparent electrode sheet 320 includes the second terminal 320P. The second terminal 320P, indicated by the halftone dots in Fig. 30, is a portion of the second transparent electrode sheet 320 exposed from the first transparent electrode sheet 310 and the light control layer. The second terminal 320P faces toward the front side of the paper in Fig. 30.

The light control sheet 300 has an edge 300E that extends in a first direction D1. The first terminal 310P and the second terminal 320P are arranged side by side at the edge 300E. Part of the edge 300E is notched to form a notch 300E1 between the first terminal 310P and the second terminal 320P.

The light control sheet 300 is connected to an external power source 340 via a flexible wiring board 330. The flexible wiring board 330 is a flexible printed circuit (FPC). The flexible wiring board 330 includes a first portion 331 and a second portion 332. The first portion 331 extends in the first direction D1. The second portion 332 extends, from the center of the first portion 331 in the first direction D1, toward the outside of the light control sheet 300 in a second direction D2 perpendicular to the first direction D1. The flexible wiring board 330 has a substantially T-shaped outline formed of the first portion 331 and the second portion 332.

The first portion 331 includes a first bonding terminal 331P1 and a second bonding terminal 331P2. The first bonding terminal 331P1 is disposed on a first side of the first portion 331 in the first direction D1. The second bonding terminal 331P2 is disposed on a second side of the first portion 331 opposite to the first side in the first direction D1. The first bonding terminal 331P1 faces toward the front side of the paper in Fig. 30. The first bonding terminal 331P1 is electrically connected to the first terminal 310P. The second bonding terminal 331P2 faces toward the rear side of the paper in Fig. 30. The second bonding terminal 331P2 is electrically connected to the second terminal 320P.

The second portion 332 includes a first power supply terminal 332P1 and a second power supply terminal 332P2. The first power supply terminal 332P1 and the second power supply terminal 332P2 are disposed at the edge of the second portion 332 in the second direction D2. The first power supply terminal 332P1 and the second power supply terminal 332P2 face toward the front side of the paper in Fig. 30. The first power supply terminal 332P1 is electrically connected to the first bonding terminal 331P1 inside the flexible wiring board 330. The second power supply terminal 332P2 is electrically connected to the second bonding terminal 331P2 inside the flexible wiring board 330. The first power supply terminal 332P1 and the second power supply terminal 332P2 are electrically connected to the external power supply 340. The external power supply 340 applies a voltage across the first transparent electrode sheet 310 and the second transparent electrode sheet 320 via the flexible wiring board 330. This causes the light control layer to change the light transmittance.

### [Citation List]

### [Patent Literature]

PTL 1: JP 2007-57925 A
PTL 2: JP 2020-38265 A

### [Summary of Invention]

### [Technical Problem]

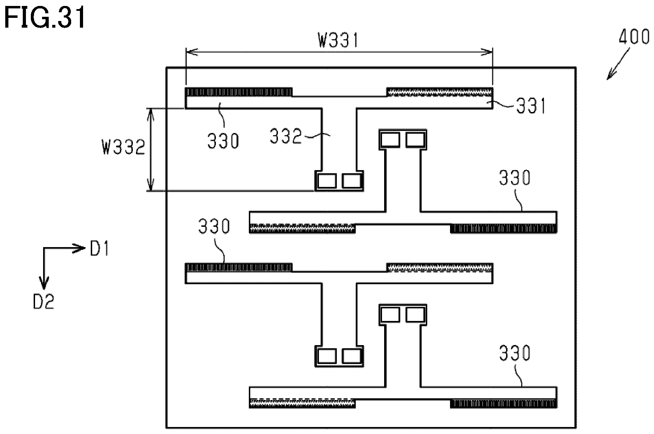

As shown in Fig. 31, in production of flexible wiring boards 330, a plurality of flexible wiring boards 330 are panelized in a laminate sheet 400 composed of two resin material layers and a conductor sandwiched therebetween. In the example shown in Fig. 31, the flexible wiring boards 330 adjacent to each other in the second direction D2 are arranged while being alternately flipped 180 degrees.

In production of flexible wiring boards 330, since the ratio of the area used for the flexible wiring boards 330 to the total area of the laminate sheet 400 is small, it is required to improve the yield. In particular, as the light control sheet 300 increases in size, the larger the width W331 of the first portion 331 in the first direction D1, the smaller the ratio of the area used for the flexible wiring boards 330 to the area of the laminate sheet 400. Similarly, the larger the width W332 of the second portion 332 in the second direction D2, the smaller the ratio of the area used for the flexible wiring boards 330 to the total area of the laminate sheet 400.

### [Solution to Problems]

In one aspect, a flexible wiring board unit is provided. A flexible wiring board unit includes: a first flexible wiring board extending in a first direction; and a second flexible wiring board extending in a second direction, wherein the second flexible wiring board is configured to be electrically connected to the first flexible wiring board on a first side of the second flexible wiring board in the second direction, the first direction and the second direction mutually intersecting, the first flexible wiring board includes a first bonding terminal and a second bonding terminal arranged in the first direction, the first bonding terminal and the second bonding terminal are configured to be connected to a power supply target, the second flexible wiring board includes a first power supply terminal and a second power supply terminal disposed on a second side which is opposite to the first side in the second direction, and the first power supply terminal and the second power supply terminal are configured to be connected to an external power supply.

In another aspect, a light control unit is provided. A light control unit includes: a light control sheet having an edge extending in a first direction; and a flexible wiring board unit bonded to the edge, wherein the light control sheet includes: a first transparent electrode sheet; a second transparent electrode sheet; and a light control layer disposed between the first transparent electrode sheet and the second transparent electrode sheet, a portion of the first transparent electrode sheet exposed from the light control layer and the second transparent electrode sheet is a first electrode terminal, a portion of the second transparent electrode sheet exposed from the light control layer and the first transparent electrode sheet is a second electrode terminal, the first electrode terminal and the second electrode terminal are arranged in the first direction at the edge, the flexible wiring board unit includes: a first flexible wiring board extending in the first direction; and a second flexible wiring board extending in the second direction, the second flexible wiring board is configured to be electrically connected to the first flexible wiring board on a first side of the second flexible wiring board in the second direction, the first direction and the second direction mutually intersecting, the first flexible wiring board includes a first bonding terminal and a second bonding terminal arranged in the first direction, the first bonding terminal is configured to be electrically connected to the first electrode terminal, the second bonding terminal is configured to be electrically connected to the second electrode terminal, the second flexible wiring board includes a first power supply terminal and a second power supply terminal disposed on a second side which is opposite to the first side in the second direction, and the first power supply terminal and the second power supply terminal are configured to be connected to an external power supply.

### [Brief Description of Drawings]

Fig. 1 is a plan view of a light control unit of a first embodiment.
Fig. 2 is a cross-sectional view taken along the line II-II in Fig. 1.
Fig. 3 is a cross-sectional view taken along the line III-III in Fig. 1.
Fig. 4 is a plan view of a first flexible wiring board and a second flexible wiring board included in a flexible wiring board unit of the first embodiment.
Fig. 5 is a plan view illustrating an example panelization of the first flexible wiring boards of the first embodiment.
Fig. 6 is a cross-sectional view of a first laminate sheet for producing a first flexible wiring board of the first embodiment.
Fig. 7 is a plan view illustrating an example panelization of the second flexible wiring boards of the first embodiment.
Fig. 8 is a cross-sectional view of a second laminate sheet for producing a second flexible wiring board of the first embodiment.
Fig. 9 is a plan view of a light control unit of a second embodiment.
Fig. 10 is a cross-sectional view taken along the line X-X in Fig. 9.
Fig. 11 is a cross-sectional view taken along the line XI-XI in Fig. 9.
Fig. 12 is a plan view of a first flexible wiring board included in a flexible wiring board unit of the second embodiment.
Fig. 13 is an enlarged view of a main part of a first relay terminal of a first flexible wiring board of the second embodiment.
Fig. 14 is a plan view of a second flexible wiring board included in a flexible wiring board unit of the second embodiment.
Fig. 15 is an enlarged view of a main part of a third relay terminal of a second flexible wiring board of the second embodiment.
Fig. 16 is a schematic view illustrating a relative positional relationship between a first relay terminal and a third relay terminal in a state in which the first relay terminal and the third relay terminal of the second embodiment are bonded to each other.
Fig. 17 is a plan view of a light control unit of a third embodiment.
Fig. 18 is a cross-sectional view taken along the line XVIII-XVIII in Fig. 17.
Fig. 19 is a cross-sectional view taken along the line XIX-XIX in Fig. 17.
Fig. 20 is a plan view of a first flexible wiring board of the third embodiment.
Fig. 21 is a plan view of a second flexible wiring board of the third embodiment.
Fig. 22 is a plan view of a first flexible wiring board of a fourth embodiment.
Fig. 23 is a plan view of a first flexible wiring board of a fifth embodiment.
Fig. 24 is a plan view of a first flexible wiring board of a fifth embodiment.
Fig. 25 is a plan view of a first flexible wiring board of a sixth embodiment.
Fig. 26 is a plan view of a first flexible wiring board of a sixth embodiment.
Fig. 27 is a plan view of a first flexible wiring board of a seventh embodiment.
Fig. 28 is a plan view of a first flexible wiring board of a seventh embodiment.
Fig. 29 is a plan view of a second flexible wiring board of a seventh embodiment.
Fig. 30 is a plan view illustrating a conventional example of a light control sheet and a flexible wiring board.
Fig. 31 is a plan view illustrating a panelization example of the flexible wiring board shown in Fig. 30.

### [Description of Embodiments]

### [Light Control Unit of First Embodiment]

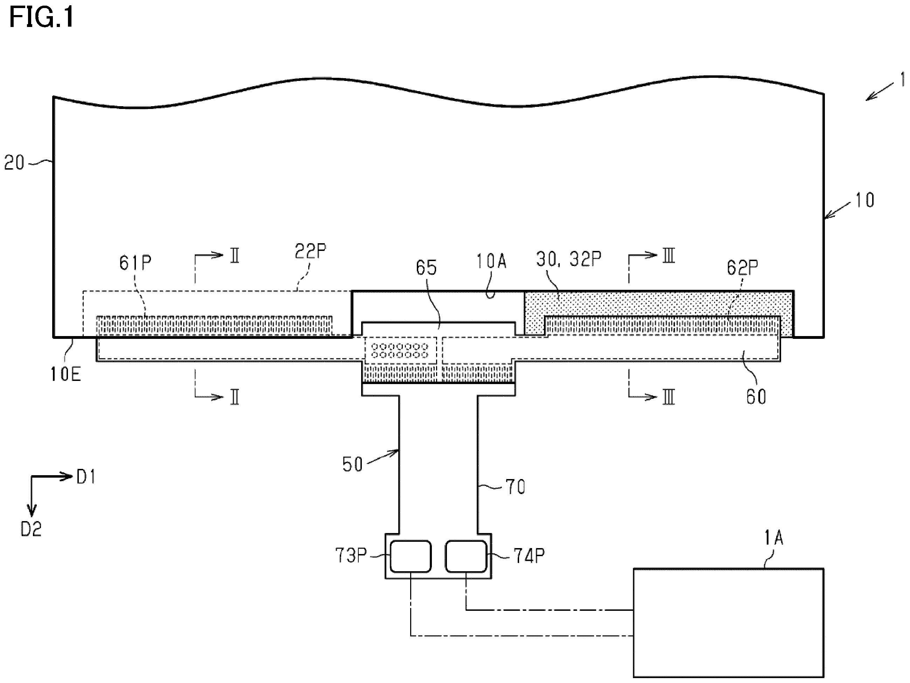

With reference to Figs. 1 to 8, a light control unit of a first embodiment will be described below.

As shown in Fig. 1, a light control unit 1 of the first embodiment includes a light control sheet 10 and a flexible wiring board unit 50. The light control sheet 10 includes an edge 10E that extends in a first direction D1. The flexible wiring board unit 50 is connected to the edge 10E of the light control sheet 10.

The light control sheet 10 includes a first transparent electrode sheet 20 and a second transparent electrode sheet 30. In Fig. 1, the first transparent electrode sheet 20 is located on a side of the second transparent electrode sheet 30 facing the front side of the paper. In Fig. 1, the second transparent electrode sheet 30 is located on a side of the first transparent electrode sheet 20 facing the rear side of the paper. Further, in Fig. 1, for the convenience of description of the relative positions of the first transparent electrode sheet 20 and the second transparent electrode sheet 30, the first transparent electrode sheet 20 is indicated by the thick line and the second transparent electrode sheet 30 is indicated by the thin line.

The space where the light control sheet 10 is provided is partitioned into two spaces by the light control sheet 10. In Fig. 1, of the two spaces partitioned by the light control sheet 10, the space on the front side of the paper and in contact with the first transparent electrode sheet 20 is a first space. In Fig. 1, of the two spaces partitioned by the light control sheet 10, the space on the rear side of the paper and in contact with the second transparent electrode sheet 30 is a second space.

The light control sheet 10 includes a first electrode terminal 22P and a second electrode terminal 32P. The first electrode terminal 22P is a portion of the first transparent electrode sheet 20 exposed from the second transparent electrode sheet 30. The first electrode terminal 22P faces the second space (in Fig. 1, rear side of the paper). The second electrode terminal 32P is a portion of the second transparent electrode sheet 30 exposed from the first transparent electrode sheet 20. The second electrode terminal 32P faces the first space (in Fig. 1, front side of the paper). The first electrode terminal 22P and the second electrode terminal 32P are arranged at a distance from each other in the first direction D1. In Fig. 1, the first electrode terminal 22P is surrounded by the dotted line and the second electrode terminal 32P is indicated by the halftone dots.

The edge 10E has a notch 10A. The notch 10A is a portion of the edge 10E recessed from the edge 10E toward the inside of the light control sheet 10. The notch 10Ais disposed at the edge 10E between the first electrode terminal 22P and the second electrode terminal 32P.

The flexible wiring board unit 50 includes a first flexible wiring board 60 extending in a first direction D1 and a second flexible wiring board 70 extending in a second direction D2 that intersects the first direction D1. In one example, the second direction D2 is perpendicular to the first direction D1. Each of the first flexible wiring board 60 and the second flexible wiring board 70 is a flexible printed circuit (FPC).

The first flexible wiring board 60 includes a first bonding terminal 61P and a second bonding terminal 62P. In one example, the first bonding terminal 61P includes tooth terminals arranged in a comb-like manner at a predetermined pitch in the first direction D1. The first bonding terminal 61P is located on the second space side of the first electrode terminal 22P (in Fig. 1, rear side of the paper). The first bonding terminal 61P is bonded and electrically connected to the first electrode terminal 22P while facing the first electrode terminal 22P.

In one example, the second bonding terminal 62P includes tooth terminals arranged in a comb-like manner at a predetermined pitch in the first direction D1. The second bonding terminal 62P is located on the first space side of the second electrode terminal 32P (in Fig. 1, front side of the paper). The second bonding terminal 62P is bonded and electrically connected to the second electrode terminal 32P while facing the second electrode terminal 32P.

The first bonding terminal 61P and the second bonding terminal 62P are arranged in the first direction D1 in the first flexible wiring board 60. The first bonding terminal 61P is disposed on one side of the first flexible wiring board 60 in the first direction D1. The second bonding terminal 62P is disposed on the other side of the first flexible wiring board 60 in the first direction D1. In other words, the first bonding terminal 61P is disposed on a first side of the first flexible wiring board 60 in the first direction D1. The second bonding terminal 62P is disposed on a second side of the first flexible wiring board 60 opposite to the first side in the first direction D1. In the first flexible wiring board 60, the first bonding terminal 61P and the second bonding terminal 62P are located on the second space side and the first space side relative to the light control sheet 10, respectively, with the notch 10A therebetween.

The first flexible wiring board 60 includes a projection 65. The projection 65 is disposed in the first flexible wiring board 60 between the first bonding terminal 61P and the second bonding terminal 62P in the first direction D1. The projection 65 projects in the second direction D2 toward the light control sheet 10. In the first direction D1, the width of the projection 65 is smaller than the width of the notch 10A. When the flexible wiring board unit 50 is attached to the light control sheet 10, the projection 65 is positioned inside the notch 10A.

For example, when the projection 65 is disposed inside the notch 10A, it is preferred that the first bonding terminal 61P is appropriately positioned relative to the first electrode terminal 22P in the first direction D1. A the same time, it is preferred that the second bonding terminal 62P is appropriately positioned relative to the second electrode terminal 32P in the first direction D1. In this case, the flexible wiring board unit 50 can be attached to an appropriate position in the first direction D1 based on the positioning of the projection 65 relative to the notch 10A.

In the second flexible wiring board 70, a first side of the second flexible wiring board 70 in the second direction D2 is physically and electrically connected to the first flexible wiring board 60 at the center of the first flexible wiring board 60 in the first direction D1. The second flexible wiring board 70 extends in the second direction D2 from the connection with the first flexible wiring board 60 toward the outside of the light control sheet 10. The flexible wiring board unit 50 has a substantially T-shaped outline formed of the first flexible wiring board 60 and the second flexible wiring board 70.

The second flexible wiring board 70 includes a first power supply terminal 73P and a second power supply terminal 74P. The first power supply terminal 73P and the second power supply terminal 74P are disposed on a second side opposite to the first side in the second direction D2. Each of the first power supply terminal 73P and the second power supply terminal 74P is connected to an external power supply 1A. The external power supply 1A applies a voltage across the first transparent electrode sheet 20 and the second transparent electrode sheet 30 via the flexible wiring board unit 50. This causes the light control sheet 10 to change the light transmittance.

### [Cross-Sectional Structure of Light Control Sheet of First Embodiment]

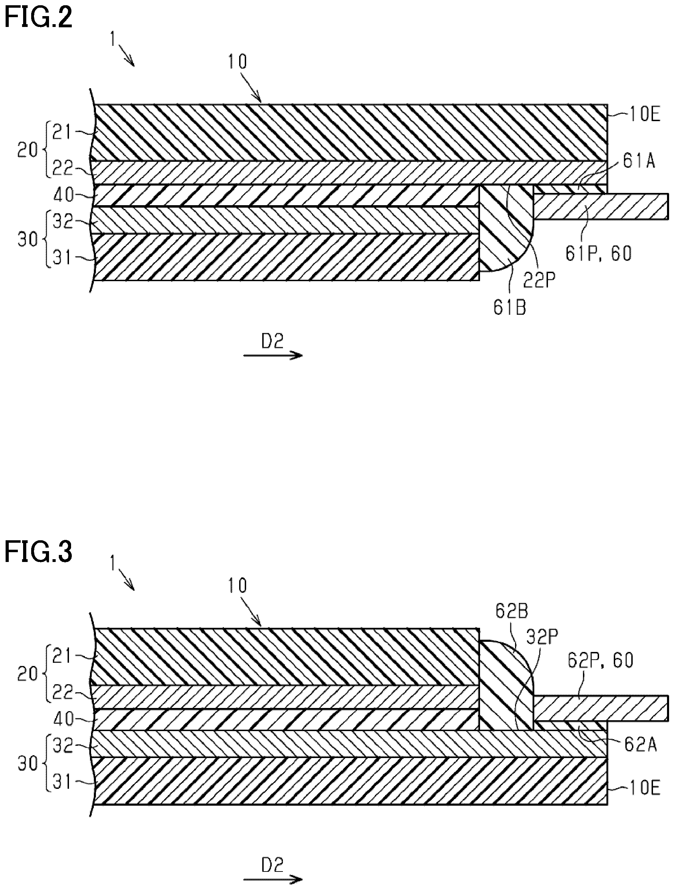

As shown in Fig.2, the light control sheet 10 includes the first transparent electrode layer 20, the second transparent electrode sheet 30 and the light control layer 40. The first transparent electrode sheet 20 includes a first transparent substrate 21 and a first transparent electrode layer 22. The second transparent electrode sheet 30 includes a second transparent substrate 31 and a second transparent electrode layer 32. The light control sheet 40 is disposed between the first transparent electrode layer 22 and the second transparent electrode layer 32. In the light control sheet 10 includes the first transparent substrate 21, the first transparent electrode layer 22, the light control layer 40, the second transparent electrode layer 32 and the second transparent substrate 31 laminated in this order.

The first transparent substrate 21 and the second transparent substrate 31 have optical transparency to visible light and electrical insulating properties. The material forming the first transparent substrate 21 and the second transparent substrate 31 is an organic polymer compound or an inorganic polymer compound. An example of the organic polymer compound is at least one selected from the group consisting of polyesters, polyacrylates, polycarbonates and polyolefins. An example of the inorganic polymer compound is at least one selected from the group consisting of silicon dioxide, silicon oxynitride and silicon nitride.

Each of the first transparent electrode layer 22 and the second transparent electrode layer 32 has optical transparency to visible light and electrical conductive properties. An example of the material for forming the first transparent electrode layer 22 and the second transparent electrode layer 32 is at least one selected from the group consisting of indium tin oxide, fluorine-doped tin oxide, tin oxide, zinc oxide, carbon nanotubes and poly 3,4-ethylenedioxythiophene.

The light control layer 40 has different light transmittance before and after application of a voltage via the first transparent electrode layer 22 and the second transparent electrode layer 32. An example of the light control layer 40 includes a transparent organic polymer layer and a liquid crystal composition. The transparent organic polymer layer defines voids between the first transparent electrode layer 22 and the second transparent electrode layer 32. The voids in the transparent organic polymer layer are filled with the liquid crystal composition. The liquid crystal composition includes a liquid crystal compound. An example of the liquid crystal compound is at least one selected from the group consisting of Schiff base compounds, azo compounds, azoxy compounds, biphenyl compounds, terphenyl compounds, benzoic acid ester compounds, tolan compounds, pyrimidine compounds, cyclohexanecarboxylic acid ester compounds, phenylcyclohexane compounds and dioxane compounds.

The type in which the transparent organic polymer layer holds the liquid crystal composition may be, for example, one selected from the group consisting of a polymer network type, polymer dispersion type and a capsule type. In the polymer network type, the transparent organic polymer layer has a transparent three-dimensional mesh polymer network and holds the liquid crystal composition in the interconnected mesh-like voids. In the polymer dispersion type, the transparent organic polymer layer has a large number of isolated voids and holds the liquid crystal composition in the voids dispersed in the transparent organic polymer layer. In the capsule type, an encapsulated liquid crystal composition is held in the transparent organic polymer layer. The liquid crystal composition may contain, in addition to the above-mentioned liquid crystal compound, a monomer for forming the transparent organic polymer layer, and a dichroic dye.

The first electrode terminal 22P is a portion of the first transparent electrode layer 22 exposed from the second transparent electrode sheet 30 and the light control layer 40. The first bonding terminal 61P of the first flexible wiring board 60 is bonded and electrically connected to the first electrode terminal 22P via a first conductive adhesive 61A. The first conductive adhesive 61A may be, for example, at least one selected from the group consisting of an anisotropic conductive film (ACF), an anisotropic conductive paste (ACP), an isotropic conductive film (ICF) and an isotropic conductive paste (ICP).

The first electrode terminal 22P is provided with a first sealing member 61B covering an edge face of the light control layer 40. The first sealing member 61B is an insulating resin. Examples of the material of the first sealing member 61B include epoxy resins and acrylic resins. The first sealing member 61B is in close contact with the first electrode terminal 22P while being in close contact with the edge face of the second transparent electrode sheet 30 and the edge face of the light control layer 40.

As shown in Fig. 3, the second electrode terminal 32P is a portion of the second transparent electrode layer 32 exposed from the first transparent electrode sheet 20 and the light control layer 40. The second bonding terminal 62P of the second flexible wiring board 60 is bonded and electrically connected to the second electrode terminal 32P via a second conductive adhesive 62A. The material of the second conductive adhesive 62A may be, for example, the same type as the first conductive adhesive 61A.

The second electrode terminal 32P is provided with a second sealing member 62B covering an edge face of the light control layer 40. The second sealing member 62B is an insulating resin, and examples thereof include epoxy resins and acrylic resins. The second sealing member 62B is in close contact with the second electrode terminal 32P while being in close contact with the edge face of the first transparent electrode sheet 20 and the edge face of the light control layer 40. The first sealing member 61B and the second sealing member 62B, which cover the edge face of the light control layer 40, prevents external leakage of the liquid crystal composition forming the light control layer 40 and suppresses deterioration of the liquid crystal composition due to acid, moisture, UV light, and the like.

### [Flexible Wiring Board Unit of First Embodiment]

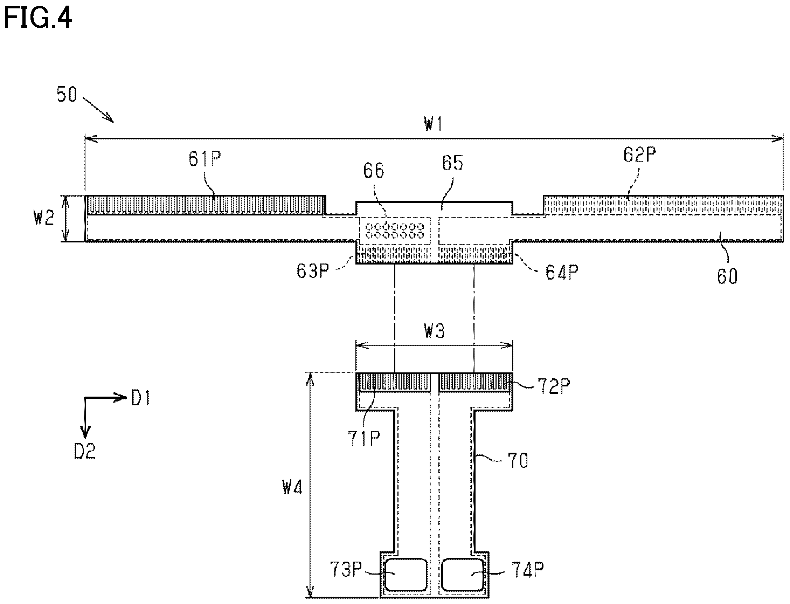

As shown in Fig. 4, in the flexible wiring board unit 50, the first flexible wiring board 60 and the second flexible wiring board 70 are electrically connected to each other, the first direction D1 and the second direction D2 mutually intersecting. The first flexible wiring board 60 has a width W1 in the first direction D1 larger than a width W2 in the second direction D2. The second flexible wiring board 70 has a width W4 in the second direction D2 larger than a width W3 in the first direction D1. In one example, the width W3 is less than 50% of the width W1, and may be, for example, 30% or less. In one example, the width W2 is less than 50% of the width W4, and may be, for example, 30% or less.

The first flexible wiring board 60 includes a first relay terminal 63P and a second relay terminal 64P. The first relay terminal 63P and the second relay terminal 64P are disposed between the first bonding terminal 61P and the second bonding terminal 62P in the first direction D1. In one example, the first relay terminal 63P and the second relay terminal 64P are disposed at the center of the first flexible wiring board 60 in the first direction D1.

In one example, the first relay terminal 63P includes tooth terminals arranged in a comb-like manner at a predetermined pitch in the first direction D1. The first relay terminal 63P is electrically connected to the first bonding terminal 61P inside the first flexible wiring board 60. The first bonding terminal 61P and the first relay terminal 63P are arranged to face opposite directions with a through hole 66 therebetween. The first bonding terminal 61P faces the front side of the paper in Fig. 4. The first relay terminal 63P faces the rear side of the paper in Fig. 4.

In one example, the second relay terminal 64P includes tooth terminals arranged in a comb-like manner at a predetermined pitch in the first direction D1. The second relay terminal 64P is electrically connected to the second bonding terminal 62P inside the first flexible wiring board 60. The second relay terminal 64P faces the same direction as the second bonding terminal 62P faces (in Fig. 4, rear side of the paper). Therefore, in the first flexible wiring board 60, the direction in which the first bonding terminal 61P faces is opposite to that in which the second bonding terminal 62P, the first relay terminal 63P and the second relay terminal 64P face.

The second flexible wiring board 70 includes a third relay terminal 71P and a fourth relay terminal 72P. The third relay terminal 71P and the fourth relay terminal 72P are disposed on the first side in the second direction D2 opposite to the second side on which the first power supply terminal 73P and the second power supply terminal 74P are disposed. In a plane including the first direction D1 and the second direction D2, the relative position of the second relay terminal 64P to the first relay terminal 63P is equal to the relative position of the fourth relay terminal 72P to the third relay terminal 71P.

In one example, the third relay terminal 71P includes tooth terminals arranged in a comb-like manner at the same pitch as the first relay terminal 63P in the first direction D1. The third relay terminal 71P is electrically connected to the first power supply terminal 73P inside the first flexible wiring board 60. In one example, the fourth relay terminal 72P includes tooth terminals arranged in a comb-like manner at the same pitch as the second relay terminal 64P in the first direction D1. The fourth relay terminal 72P is electrically connected to the second power supply terminal 74P inside the first flexible wiring board 60. In the second flexible wiring board 70, the third relay terminal 71P, the fourth relay terminal 72P, the first power supply terminal 73P and the second power supply terminal 74P face the same direction (in Fig. 4, front side of the paper).

The third relay terminal 71P is electrically connected to the first relay terminal 63P while facing the first relay terminal 63P. The fourth relay terminal 72P is electrically connected to the second relay terminal 64P while facing the second relay terminal 64P. For the connection between the first relay terminal 63P and the third relay terminal 71P and the connection between the second relay terminal 64P and the fourth relay terminal 72P, for example, an adhesive made of at least one selected from the group consisting of an anisotropic conductive film, an anisotropic conductive paste, an isotropic conductive film and an isotropic conductive paste is used. The first flexible wiring board 60 and the second flexible wiring board 70 are integrally connected by the connection between the first relay terminal 63P and the third relay terminal 71P and the connection between the second relay terminal 64P and the fourth relay terminal 72P.

The first bonding terminal 61P is electrically connected to the first power supply terminal 73P via the first relay terminal 63P and the third relay terminal 71P. Therefore, the external power supply 1A is electrically connected to the first transparent electrode sheet 20 via the first power supply terminal 73P, the third relay terminal 71P, the first relay terminal 63P, the first bonding terminal 61P, the first electrode terminal 22P.

The second bonding terminal 62P is electrically connected to the second power supply terminal 74P via the second relay terminal 64P and the fourth relay terminal 72P. Therefore, the external power supply 1Ais electrically connected to the second transparent electrode sheet 30 via the second power supply terminal 74P, the fourth relay terminal 72P, the second relay terminal 64P, the second bonding terminal 62P, the second electrode terminal 32P.

### [Panelization of Flexible Wiring Boards]

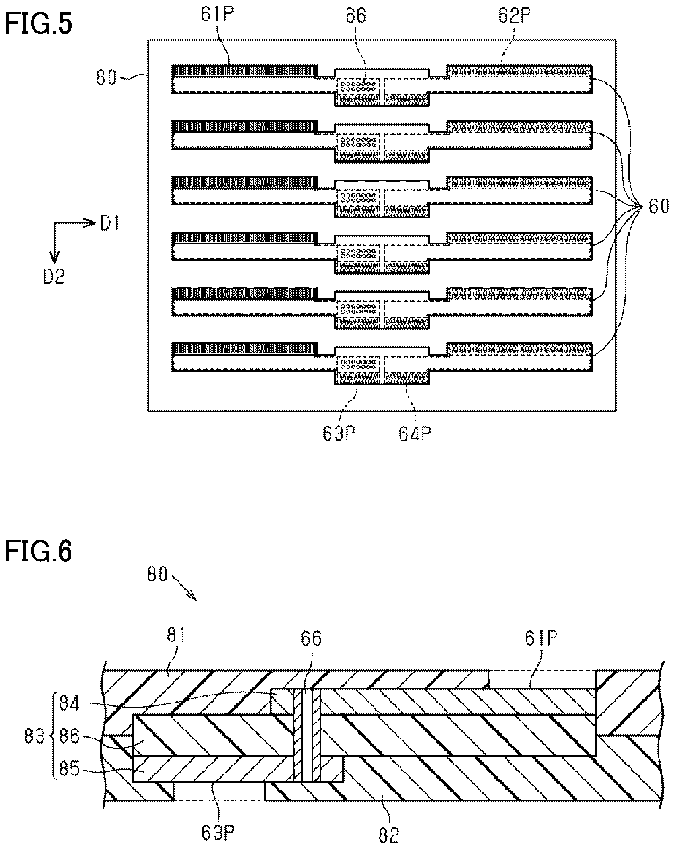

As shown in Fig. 5, in production of first flexible wiring boards 60, a plurality of first flexible wiring boards 60 are panelized in a first laminate sheet 80 in which materials for forming first flexible wiring boards 60 are laminated. In one example, in the first laminate sheet 80, a plurality of first flexible wiring boards 60 are panelized in the second direction D2.

As shown in Fig. 6, the first laminate sheet 80 has a double-sided structure which includes two outer film layers 81 and 82 and a double-sided conductive layer 83 interposed between the two outer film layers 81 and 82. In one example, the double-sided conductive layer 83 includes two conductive layers 84 and 85 having conductivity and an inner film layer 86 interposed between the two conductive layers 84 and 85. The two outer film layers 81 and 82 and the inner film layer 86 are insulating resin films, and may be made of, for example, polyimide. The two outer film layers 81 and 82 and the inner film layer 86 are example insulating layers. The two conductive layers 84 and 85 are made of, for example, copper foil. The conductive layer 84 is in contact with the outer film layer 81. The conductive layer 85 is in contact with the outer film layer 82. The first flexible wiring board 60 having a double-sided structure includes the outer film layer 81, the conductive layer 84, the inner film layer 86, the conductive layer 85 and the outer film layer 82 laminated in this order. In the double-sided structure, a plurality of terminals included in each flexible wiring board face opposite directions. In other words, in the flexible wiring board having a double-sided structure, a plurality of terminals included in each flexible wiring board can be arranged to face any of two opposite directions.

Further, in Fig. 6, the first bonding terminal 61P, the first relay terminal 63P and the through hole 66 are schematically illustrated in a single cross-sectional view. The first bonding terminal 61P is a portion where the conductive layer 84 is exposed due to the outer film layer 81 being removed. The first relay terminal 63P is a portion where the conductive layer 85 is removed due to the outer film layer 82 being removed. The first bonding terminal 61P and the first relay terminal 63P face opposite directions. The two conductive layers 84 and 85 disposed between the first bonding terminal 61P and the first relay terminal 63P are electrically connected to each other via the through hole 66. Further, the second bonding terminal 62P and the second relay terminal 64P are portions where the conductive layer 85 is exposed due to the outer film layer 82 being removed. The second bonding terminal 62P and the second relay terminal 64P face the same direction as the first relay terminal 63P faces.

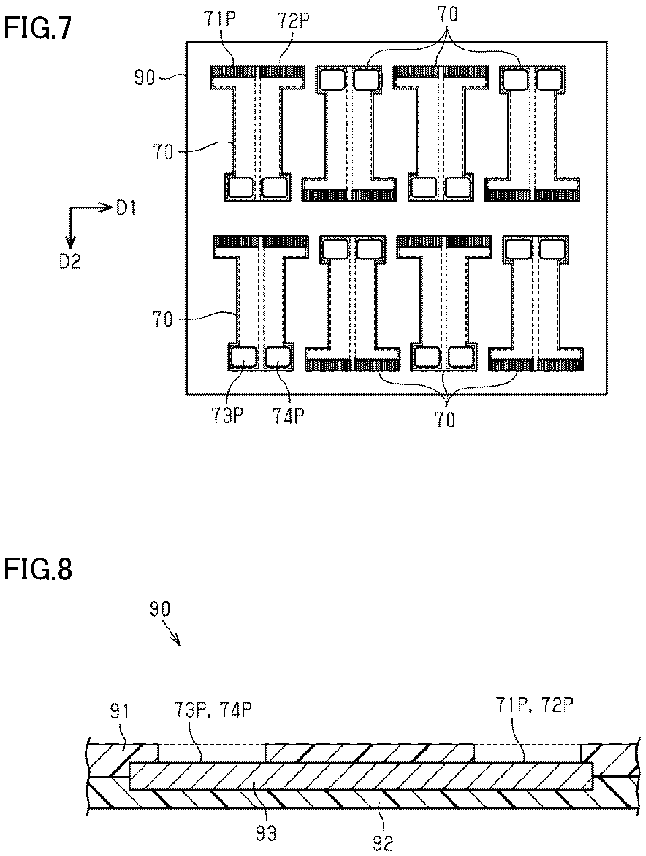

As shown in Fig. 7, in production of second flexible wiring boards 70, a plurality of second flexible wiring boards 70 are panelized in a second laminate sheet 90 in which materials for forming second flexible wiring boards 70 are laminated. In one example, in the second laminate sheet 90, a plurality of second flexible wiring boards 70 are arranged in the second direction D2, and the second flexible wiring boards 70 adjacent to each other in the first direction D1 are panelized while being alternately flipped 180 degrees.

As shown in Fig. 8, the second laminate sheet 90 has a single-sided structure which includes two film layers 91 and 92 and a conductive layer 93 interposed between the two film layers 91 and 92. The two film layers 91 and 92 are insulating resin films, and may be made of, for example, polyimide. The two film layers 91 and 92 are example insulating layers. The conductive layer 93 is made of, for example, copper foil. The second flexible wiring board 70 having a single-sided structure includes the film layer 91, the conductive layer 93 and the film layer 92 laminated in this order. The second flexible wiring board 70 having a single-sided structure includes fewer layers in the lamination direction than the first flexible wiring board 60 having a double-sided structure does. In the single-sided structure, a plurality of terminals in each flexible wiring board face in one direction. In other words, in the flexible wiring board having a single-sided structure, a plurality of terminals included in each flexible wiring board are arranged to face one same direction.

Further, in Fig. 8, the third relay terminal 71P, the fourth relay terminal 72P, the first power supply terminal 73P and the second power supply terminal 74P are schematically illustrated in a single cross-sectional view. The third relay terminal 71P, the fourth relay terminal 72P, the first power supply terminal 73P and the second power supply terminal 74P are portions where the conductive layer 93 is exposed due to the film layer 91 being removed. The third relay terminal 71P, the fourth relay terminal 72P, the first power supply terminal 73P and the second power supply terminal 74P face the same direction.

In the flexible wiring board unit 50, the first flexible wiring board 60 and the second flexible wiring board 70, which extend in different directions, are separately produced and then integrally connected to each other. Accordingly, the first flexible wiring boards 60 can be efficiently panelized in the first laminate sheet 80, increasing the yield. Similarly, the second flexible wiring boards 70 can be efficiently panelized in the second laminate sheet 90, increasing the yield. Therefore, the yield can be improved compared to the case where the first flexible wiring board 60 and the second flexible wiring boards 70 are produced as a single flexible wiring board.

Producing the first flexible wiring board 60 and the second flexible wiring board 70 separately makes it possible to provide the first flexible wiring board 60 with a double-sided structure while providing the second flexible wiring board 70 with a single-sided structure. If the first flexible wiring board 60 and the second flexible wiring board 70 are produced as a single flexible wiring board, the entire flexible wiring board is formed of the first laminate sheet 80 having a double-sided structure. Compared to the first laminate sheet 80 having a double-sided structure, the second laminate sheet 90 having a single-sided structure has reduced thickness due to the fewer constituent layers, and thus has high flexibility and bending resistance. In addition, the production cost is reduced due to the fewer constituent layers. Therefore, since the first flexible wiring board 60 has a double-sided structure while the second flexible wiring board 70 has a single-sided structure, the second flexible wiring board 70 can simplify the layer configuration and increase the flexibility. Further, compared to the case where the entire flexible wiring board unit 50 has a double-sided structure, the production cost can be reduced.

The first relay terminal 63P and the second relay terminal 64P are arranged to face the same direction in the first flexible wiring board 60. Similarly, the third relay terminal 71P and the fourth relay terminal 72P are arranged to face the same direction in the second flexible wiring board 70. Therefore, the connection between the first relay terminal 63P and the third relay terminal 71P and the connection between the second relay terminal 64P and the fourth relay terminal 72P can be simultaneously performed. Accordingly, the connection between the first flexible wiring board 60 and the second flexible wiring board 70 can be efficiently performed.

### [Advantageous Effects of First Embodiment]

According to the first embodiment, the advantageous effects listed below can be achieved.
(1-1) In the flexible wiring board unit 50, the first flexible wiring board 60 and the second flexible wiring board 70, which extend in different directions, are separately produced and then integrally connected to each other. Accordingly, each of the first flexible wiring board 60 and the second flexible wiring board 70 can be efficiently panelized, increasing the yield. Therefore, the yield can be improved compared to the case where the first flexible wiring board 60 and the second flexible wiring boards 70 are produced as a single flexible wiring board.
(1-2) While the first flexible wiring board 60 has a double-sided structure, the second flexible wiring board 70 has a single-sided structure. Accordingly, compared to the case where the entire flexible wiring board unit 50 has a double-sided structure, the layer configuration of the second flexible wiring board 70 can be simplified. Therefore, the flexibility of the second flexible wiring board 70 can be improved. Further, the production cost can also be reduced.
(1-3) Since the first relay terminal 63P and the second relay terminal 64P are arranged to face the same direction and the third relay terminal 71P and the fourth relay terminal 72P are arranged to face the same direction, efficient connection between the first flexible wiring board 60 and the second flexible wiring board 70 can be performed.

### [Modifications of First Embodiment]

The first embodiment can be modified and implemented as follows. The modifications described below can be combined with each other as long as no technical contradiction occurs.

- The second flexible wiring board 70 may be connected to the first flexible wiring board 60 at a position displaced toward one side from the center of the first flexible wiring board 60 in the first direction D1. That is, the first relay terminal 63P and the second relay terminal 64P may be positioned displaced toward the first bonding terminal 61P or the second bonding terminal 62P in the first direction D1. For example, the first relay terminal 63P and the second relay terminal 64P may be positioned on one side of the first flexible wiring board 60 in the first direction D1. In this case, the second flexible wiring board 70 is connected to the first flexible wiring board 60 on one side of the first flexible wiring board 60 in the first direction D1. This increases the degree of freedom in wiring path from the light control sheet 10 as an example power supply target to the external power supply 1A. In this case as well, advantageous effects similar to the above (1-1) and (1-2) can be achieved. Furthermore, if a flexible wiring board unit 50 having a configuration in which the first flexible wiring board 60 and the second flexible wiring board 70 are connected at the center of the first flexible wiring board 60 in the first direction D1 is produced as a single flexible wiring board, the panelization efficiency is particularly poor. In this case, by separately producing the first flexible wiring board 60 and the second flexible wiring board 70, the effect of improving the yield can be greatly improved compared to the case where the flexible wiring board unit 50 is produced as a single flexible wiring board.
- In the example described above, the first direction D1 is perpendicular to the second direction D2. However, the second direction D2 may be any direction intersecting the first direction D1. For example, the second flexible wiring board 70 may be connected obliquely to the first flexible wiring board 60. In this case as well, advantageous effects similar to the above (1-1) and (1-2) can be achieved. Furthermore, if a flexible wiring board unit 50 having a configuration in which two flexible wiring boards have extending directions perpendicular to each other, such as the combination of the first flexible wiring board 60 and the second flexible wiring board 70, is produced as a single flexible wiring board, the panelization efficiency is particularly poor. In this regard, by separately producing the first flexible wiring board 60 and the second flexible wiring board 70 having extending directions perpendicular to each other, the effect of improving the yield can be greatly improved compared to the case where the flexible wiring board unit 50 is produced as a single flexible wiring board.
- The second flexible wiring board 70 may have a double-sided structure. For example, the first power supply terminal 73P and the second power supply terminal 74P may face opposite directions. In this case, a through hole is provided between the third relay terminal 71P and the first power supply terminal 73P or between the fourth relay terminal 72P and the second power supply terminal 74P. This increases the degree of freedom in the form of connection of the first power supply terminal 73P and the second power supply terminal 74P to the external power supply 1A.

### [Light Control Unit of Second Embodiment]

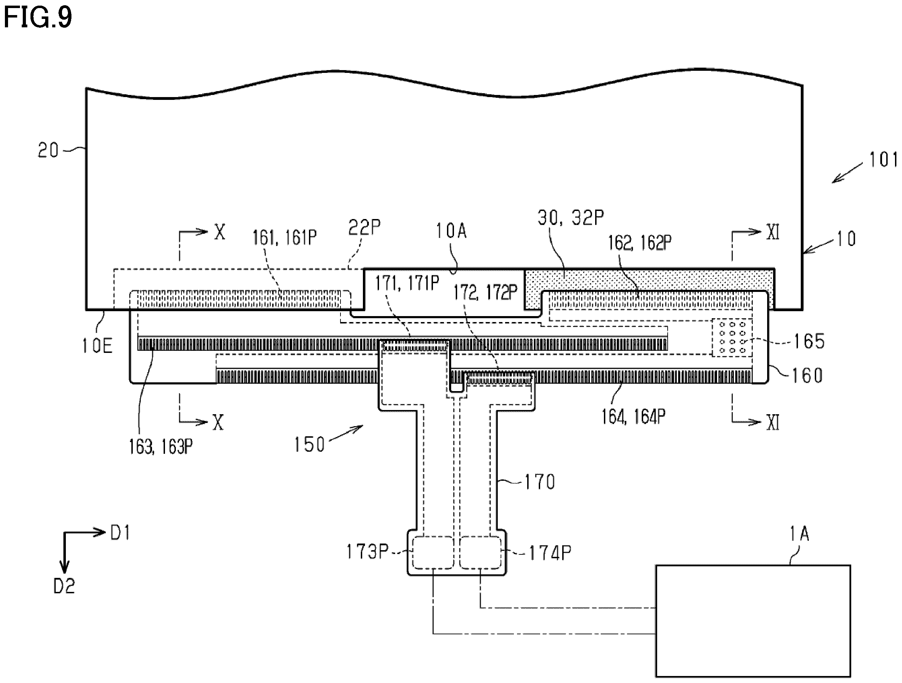

With reference to Figs. 9 to 16, a light control unit of a second embodiment will be described below.

As shown in Fig. 9, a light control unit 101 of the second embodiment includes the same light control sheet 10 as in the first embodiment and a flexible wiring board unit 150. The flexible wiring board unit 150 is connected to the edge 10E of the light control sheet 10.

The flexible wiring board unit 150 includes a first flexible wiring board 160 extending in a first direction D1 and a second flexible wiring board 170 extending in a second direction D2 that intersects the first direction D1. In other words, in the flexible wiring board unit 150, the first flexible wiring board 160 and the second flexible wiring board 170 are electrically connected to each other, the first direction D1 and the second direction D2 mutually intersecting. The first flexible wiring board 160 is responsible for electrical connection to the light control sheet 10, which is a power supply target, in the flexible wiring board unit 150. The second flexible wiring board 170 is responsible for electrical connection to the external power supply 1A in the flexible wiring board unit 150.

Each of the first flexible wiring board 160 and the second flexible wiring board 170 is a flexible printed circuit (FPC). The first flexible wiring board 160 includes a first bonding terminal 161 and a second bonding terminal 162. The first bonding terminal 161 and the second bonding terminal 162 are arranged in the first direction D1 in the first flexible wiring board 160. The first bonding terminal 161 is disposed on one side of the first flexible wiring board 160 in the first direction D1. The second bonding terminal 162 is disposed on the other side of the first flexible wiring board 160 in the first direction D1. In other words, the first bonding terminal 161 is disposed on a first side of the first flexible wiring board 160 in the first direction D1. The second bonding terminal 162 is disposed on a second side of the first flexible wiring board 160 opposite to the first side in the first direction D1.

The first bonding terminal 161 is located on the second space side of the first electrode terminal 22P (in Fig. 9, rear side of the paper), and faces the first space side (in Fig. 9, front side of the paper). The first bonding terminal 161 includes a plurality of first bonding tooth terminals 161P arranged in a comb-like manner at a predetermined pitch in the first direction D1. The first bonding tooth terminals 161P are bonded and electrically connected to the first electrode terminal 22P while facing the first electrode terminal 22P.

The second bonding terminal 162 is located on the first space side of the second electrode terminal 32P (in Fig. 9, front side of the paper), and faces the second space side (in Fig. 9, rear side of the paper). The second bonding terminal 162 includes a plurality of second bonding tooth terminals 162P arranged in a comb-like manner at a predetermined pitch in the first direction D1. The second bonding tooth terminals 162P are bonded and electrically connected to the second electrode terminal 32P while facing the second electrode terminal 32P.

The first flexible wiring board 160 includes a first relay terminal 163 and a second relay terminal 164. The first relay terminal 163 and the second relay terminal 164 are arranged in the first flexible wiring board 160 at a predetermined distance from each other in the second direction D2. The first relay terminal 163 and the second relay terminal 164 face the first space side (in Fig. 9, front side of the paper).

The first bonding terminal 161 and the second bonding terminal 162 are disposed on one side of the first flexible wiring board 160 in the second direction D2. The second relay terminal 164 is positioned on the other side of the first flexible wiring board 160 in the second direction D2, which is opposite to the side on which the first bonding terminal 161 and the second bonding terminal 162 are positioned. In other words, the first bonding terminal 161 and the second bonding terminal 162 are disposed on a first side of the first flexible wiring board 160 in the second direction D2. The second relay terminal 164 is disposed on the side of the first flexible wiring board 160 opposite to the side on which the first bonding terminal 161 and the second bonding terminal 162 are disposed in the second direction D2, that is, on a second side opposite to the first side. The first relay terminal 163 is disposed between the first and second bonding terminals 161 and 162 and the second relay terminal 164 in the second direction D2.

The first relay terminal 163 includes a plurality of first tooth terminals 163P arranged in a comb-like manner at a predetermined pitch in the first direction D1. **In** one example of the first relay terminal 163, the plurality of first tooth terminals 163P are arranged in the first direction D1 from the position of the first bonding terminal 161 to the position of the second bonding terminal 162.

The second relay terminal 164 includes a plurality of second tooth terminals 164P arranged in a comb-like manner at a predetermined pitch in the first direction D1. **In** one example of the second relay terminal 164, the plurality of second tooth terminals 164P are arranged in the first direction D1 from the position of the first bonding terminal 161 to the position of the second bonding terminal 162.

A first side of the second flexible wiring board 170 in the second direction D2 is physically and electrically connected to the first flexible wiring board 160. The second flexible wiring board 170 extends in the second direction D2 from the connection with the first flexible wiring board 160 toward the outside of the light control sheet 10. In one example, the flexible wiring board unit 150 has a substantially T-shaped outline formed of the first flexible wiring board 160 and the second flexible wiring board 170.

The second flexible wiring board 170 includes a third relay terminal 171 and a fourth relay terminal 172. The third relay terminal 171 and the fourth relay terminal 172 are disposed on the first side of the second flexible wiring board 170 in the second direction D2. The third relay terminal 171 and the fourth relay terminal 172 are arranged in the first direction D1 while the fourth relay terminal 172 is spaced at a predetermined distance from the third relay terminal 171 in the second direction D2. The third relay terminal 171 and the fourth relay terminal 172 face the second space side (in Fig. 9, rear side of the paper).

The third relay terminal 171 includes a plurality of third tooth terminals 171P arranged in a comb-like manner at a predetermined pitch in the first direction D1. The fourth relay terminal 172 includes a plurality of fourth tooth terminals 172P arranged in a comb-like manner at a predetermined pitch in the first direction D1. The first tooth terminals 163P, the second tooth terminals 164P, the third tooth terminals 171P and the fourth tooth terminals 172P are arranged at the same pitch.

In one example, the number of the first tooth terminals 163P is the same as the number of the second tooth terminals 164P. In one example, the number of the third tooth terminals 171P is the same as the number of the fourth tooth terminals 172P. The number of the first tooth terminals 163P is greater than the number of the third tooth terminals 171P. The number of the second tooth terminals 164P is greater than the number of the fourth tooth terminals 172P.

Each of the third tooth terminals 171P is physically and electrically connected to corresponding one of the plurality of first tooth terminals 163P. Similarly, each of the fourth tooth terminals 172P is physically and electrically connected to corresponding one of the plurality of second tooth terminals 164P. Accordingly, the first flexible wiring board 160 and the second flexible wiring board 170 are physically and electrically connected.

The second flexible wiring board 170 includes a first power supply terminal 173P and a second power supply terminal 174P. The first power supply terminal 173P and the second power supply terminal 174P are disposed on the second side in the second direction D2 opposite to the first side on which the third relay terminal 171 and the fourth relay terminal 172 are disposed. Each of the first power supply terminal 173P and the second power supply terminal 174P is connected to the external power supply 1A. The external power supply 1A applies a voltage across the first transparent electrode sheet 20 and the second transparent electrode sheet 30 via the flexible wiring board unit 150. This causes the light control sheet 10 to change the light transmittance. The light control sheet 10 is an example power supply target to which the external power supply 1A supplies power via the flexible wiring board unit 150.

### [Cross-Sectional Structure of Light Control Unit of Second Embodiment]

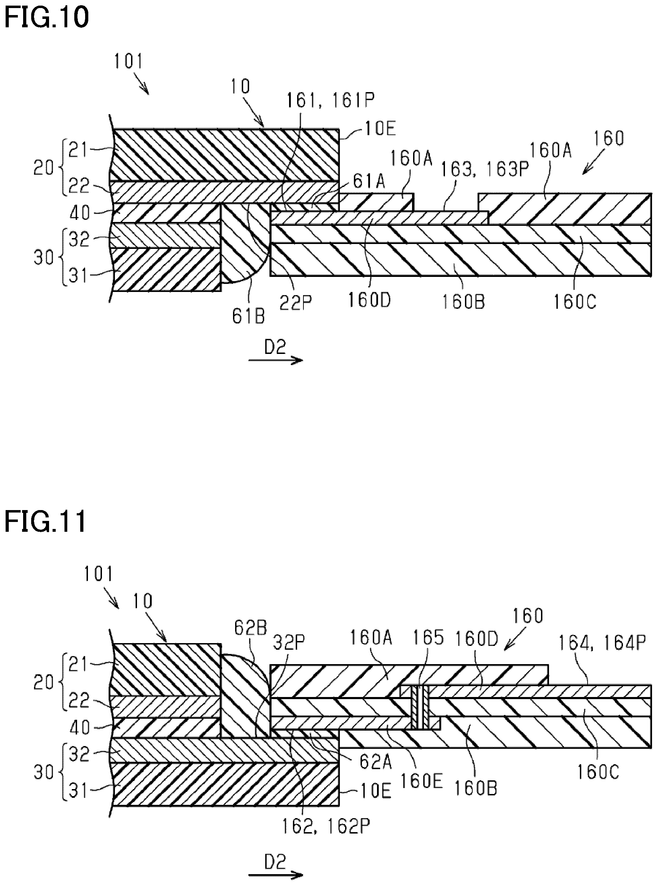

As shown in Figs. 10 and 11, the first flexible wiring board 160 includes a first outer insulating layer 160A, a second outer insulating layer 160B, an inner insulating layer 160C, a first conductive layer 160D and a second conductive layer 160E (see Fig. 11). The inner insulating layer 160C is disposed between the first outer insulating layer 160A and the second outer insulating layer 160B. The first outer insulating layer 160A is located on a side of the inner insulating layer 160C facing the first space which is partitioned by the light control sheet 10. The second outer insulating layer 160B is located on a side of the inner insulating layer 160C facing the second space partitioned by the light control sheet 10. The first outer insulating layer 160A, the second outer insulating layer 160B and the inner insulating layer 160C are insulating resin films, and may be made of, for example, polyimide.

The first conductive layer 160D is disposed between the first outer insulating layer 160A and the inner insulating layer 160C. The second conductive layer 160E is disposed between the second outer insulating layer 160B and the inner insulating layer 160C. The first conductive layer 160D and the second conductive layer 160E are conductive metal films, and may be made of, for example, copper foil. In the cross-section shown in Fig. 10, the second conductive layer 160E is not disposed. Further, the first conductive layer 160D shown in Fig. 10 is electrically isolated from the first conductive layer 160D shown in Fig. 11. The first flexible wiring board 160 having a double-sided structure includes the first outer insulating layer 160A, the first conductive layer 160D, the inner insulating layer 160C, the second conductive layer 160E and the second outer insulating layer 160B laminated in this order.

As shown in Fig. 10, the first bonding terminal 161 and the first relay terminal 163 are portions of the first flexible wiring board 160 where the first conductive layer 160D is exposed from the first outer insulating layer 160A. The first bonding terminal 161 is electrically connected to the first relay terminal 163 via the first conductive layer 160D inside the first flexible wiring board 160.

The first bonding terminal 161 is electrically connected to the first electrode terminal 22P via the first conductive adhesive 61A. The first electrode terminal 22P is provided with a first sealing member 61B covering an edge face of the light control layer 40.

As shown in Fig. 11, the second bonding terminal 162 is a portion of the first flexible wiring board 160 where the second conductive layer 160E is exposed from the second outer insulating layer 160B. The second relay terminal 164 is a portion of the first flexible wiring board 160 where the first conductive layer 160D is exposed from the first outer insulating layer 160A. The second conductive layer 160E constituting the second bonding terminal 162 and the first conductive layer 160D constituting the second relay terminal 164 are electrically connected via a through hole 165.

The second bonding terminal 162 of the first flexible wiring board 160 is bonded and electrically connected to the second electrode terminal 32P via the second conductive adhesive 62A. The second electrode terminal 32P is provided with a second sealing member 62B covering an edge face of the light control layer 40.

### [First Flexible Wiring Board of Second Embodiment]

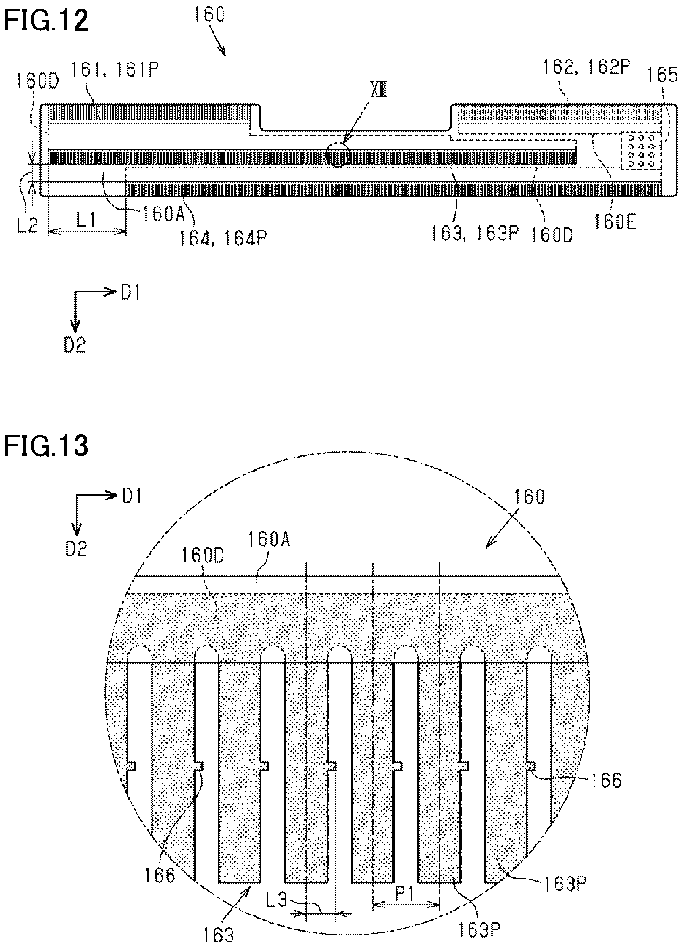

As shown in Fig. 12, the first relay terminal 163 and the second relay terminal 164 have the same length in the first direction D1. The second relay terminal 164 is displaced by a distance L1 from the first relay terminal 163 in the first direction D1 toward the second bonding terminal 162. The first flexible wiring board 160 includes a plurality of through holes 165 between the second bonding terminal 162-side end and the first relay terminal 163 in the first direction D1. The second relay terminal 164 is spaced at a predetermined distance L2 from the first relay terminal 163 in the second direction D2.

Next, with reference to Fig. 13, the first tooth terminals 163P will be described. In Fig. 13, the first conductive layer 160D is indicated by thin halftone dots. Since the second tooth terminals 164P have the same configuration as that of the first tooth terminals 163P, the detailed description thereof will be omitted.

As shown in Fig. 13, a plurality of first tooth terminals 163P are arranged at a predetermined pitch P1 in the first direction D1. Each of the first tooth terminals 163P has a first projection 166. The first projection 166 is an example of a reference portion for arranging the third tooth terminals 171P in appropriate positions relative to the first tooth terminals 163P in each of the first direction D1 and the second direction D2. In one example, the first projection 166 projects from the side edge of the first tooth terminal 163P from the first bonding terminal 161-side toward the second bonding terminal 162-side in the first direction D1. In the first direction D1, the length from the center of a portion of the first tooth terminal 163P extending in the second direction D2 to the tip of the first projection 166 is a distance L3. In one example, the first projection 166 is disposed at substantially the center of the first tooth terminals 163P in the second direction D2.

### [Second Flexible Wiring Board of Second Embodiment]

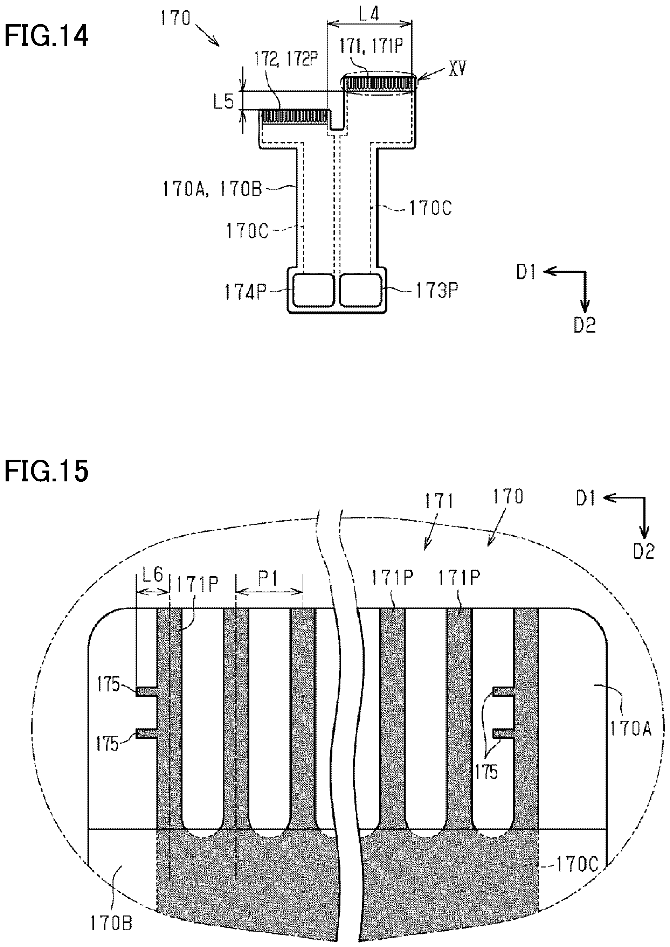

Next, with reference to Fig. 14, the second flexible wiring board 170 will be described. In Fig. 14, the second flexible wiring board 170 has been inverted from the state shown in Fig. 9.

As shown in Fig. 14, the second flexible wiring board 170 includes a third outer insulating layer 170A, a fourth outer insulating layer 170B and a conductive layer 170C. The conductive layer 170C is disposed between the third outer insulating layer 170A and the fourth outer insulating layer 170B The third outer insulating layer 170A is located on the first space side of the conductive layer 170C (in Fig. 14, rear side of the paper). The fourth outer insulating layer 170B is located on the second space side of the conductive layer 170C (in Fig. 14, front side of the paper). The third outer insulating layer 170A and the fourth outer insulating layer 170B are insulating resin films, and may be made of, for example, polyimide. The conductive layer 170C is a conductive metal film, and may be made of, for example, copper foil. The second flexible wiring board 170 having a single-sided structure includes the third outer insulating layer 170A, the conductive layer 170C and the fourth outer insulating layer 170B laminated in this order. The second flexible wiring board 170 having a single-sided structure includes fewer layers in the lamination direction than the first flexible wiring board 160 having a double-sided structure does.

The third relay terminal 171, the fourth relay terminal 172, the first power supply terminal 173P and the second power supply terminal 174P of the second flexible wiring board 170 are portions where the conductive layer 170C is exposed from the fourth outer insulating layer 170B. The conductive layer 170C electrically connects the third relay terminal 171 with the first power supply terminal 173P and electrically connects the fourth relay terminal 172 with the second power supply terminal 174P inside the second flexible wiring board 170. Further, in the conductive layer 170C, a portion connecting the third relay terminal 171 with the first power supply terminal 173P is electrically insulated from a portion connecting the fourth relay terminal 172 with the second power supply terminal 174P.

In the first direction D1, the length of the third relay terminal 171 is the same as the length of the fourth relay terminal 172. In the first direction D1, a distance L4 from the end of the third relay terminal 171 farther from the fourth relay terminal 172 to the end of the fourth relay terminal 172 closer to the third relay terminal 171 is equal to the distance L1. In the second direction D2, the fourth relay terminal 172 is spaced at a predetermined distance L5 from the third relay terminal 171. The distance L5 is equal to the distance L2.

With this configuration, when each of the third tooth terminals 171P is electrically connected to corresponding one of the plurality of first tooth terminals 163P, each of the fourth tooth terminals 172P is electrically connected to corresponding one of the plurality of second tooth terminals 164P. In other words, the third relay terminal 171 is positioned relative to the fourth relay terminal 172 such that when each of the third tooth terminals 171P is connected to the first tooth terminals 163P, each of the fourth tooth terminals 172P is connected to the second tooth terminals 164P.

In the first flexible wiring board 160, the second bonding terminal 162 is disposed to face the direction opposite to that in which the first bonding terminal 161, the first relay terminal 163 and the second relay terminal 164 face due to the three insulating layers 160A to 160C and two conductive layers 160D and 160E. On the other hand, in the second flexible wiring board 170, the third relay terminal 171, the fourth relay terminal 172, the first power supply terminal 173P and the second power supply terminal 174P are disposed to face the same direction due to the two insulating layers 170A and 170B and one conductive layer 170C. With this configuration, even when the first bonding tooth terminals 161P and the second bonding tooth terminals 162P are required to face opposite directions, the layer configuration of the second flexible wiring board 170 can be simplified. As a result, the bending resistance and flexibility of the second flexible wiring board 170 can be improved due to the fewer constituent layers.

Next, with reference to Fig. 15, the third tooth terminals 171P will be described. In Fig. 15, the conductive layer 170C is indicated by thick halftone dots. Since the fourth tooth terminals 172P have the same configuration as that of the third tooth terminals 171P, the detailed description thereof will be omitted.

As shown in Fig. 15, a plurality of third tooth terminals 171P are arranged at a predetermined pitch P1 in the first direction D1. Among the plurality of third tooth terminals 171P, the third tooth terminal 171P positioned on each end in the first direction D1 has two second projections 175. The second projection 175 is an example of a registration portion for arranging the third tooth terminals 171P in appropriate positions relative to the first tooth terminals 163P in each of the first direction D1 and the second direction D2.

In one example, the second projections 175 project from the side edge of the third tooth terminals 171P from the third relay terminal 171-side toward the fourth relay terminal 172-side in the first direction D1. In the first direction D1, the length from the center of a portion of the third tooth terminal 171P extending in the second direction D2 to the tip of the second projection 175 is a distance L6. In one example, the distance L6 is greater than the distance L3. In one example, the two second projections 175 are arranged in the second direction D2 at an interval greater than the width of the first projection 166.

### [Connection between First Flexible Wiring Board and Second Flexible Wiring Board of Second Embodiment]

Each of the third tooth terminals 171P faces and is electrically connected to corresponding one of the plurality of first tooth terminals 163P. At the same time, each of the fourth tooth terminals 172P faces and is electrically connected to corresponding one of the plurality of second tooth terminals 164P. For the connection between the first tooth terminals 163P and the third tooth terminals 171P and the connection between the second tooth terminals 164P and the fourth tooth terminals 172P, for example, an adhesive made of at least one selected from the group consisting of an anisotropic conductive film, an anisotropic conductive paste, an isotropic conductive film and an isotropic conductive paste is used.

The first flexible wiring board 160 and the second flexible wiring board 170 are integrally connected by the connection between the first tooth terminals 163P and the third tooth terminals 171P and the connection between the second tooth terminals 164P and the fourth tooth terminals 172P. The first tooth terminals 163P and the second tooth terminals 164P face the same direction and the third tooth terminals 171P and the fourth tooth terminals 172P face the same direction. Therefore, the connection between the first tooth terminals 163P and the third tooth terminals 171P and the connection between the second tooth terminals 164P and the fourth tooth terminals 172P can be simultaneously performed.

In the flexible wiring board unit 150, the arrangement of the third tooth terminals 171P relative to the first tooth terminals 163P and the arrangement of the fourth tooth terminals 172P relative to the second tooth terminals 164P can be varied for each pitch P1. That is, in the flexible wiring board unit 150, the arrangement of the second flexible wiring board 170 relative to the first flexible wiring board 160 in the first direction D1 can be varied for each pitch P1.

The first bonding terminal 161 is electrically connected to the external power supply 1A via the first relay terminal 163, the third relay terminal 171 and the first power supply terminal 173P. The second bonding terminal 162 is electrically connected to the external power supply 1A via the second relay terminal 164, the fourth relay terminal 172 and the second power supply terminal 174P.

Among the plurality of first tooth terminals 163P, the first tooth terminal 163P that is not connected to the third tooth terminal 171P may be sealed by, for example, applying and curing an insulating resin paste. Similarly, among the plurality of second tooth terminals 164P, the second tooth terminal 164P that is not connected to the fourth tooth terminal 172P may be sealed by, for example, applying and curing an insulating resin paste.

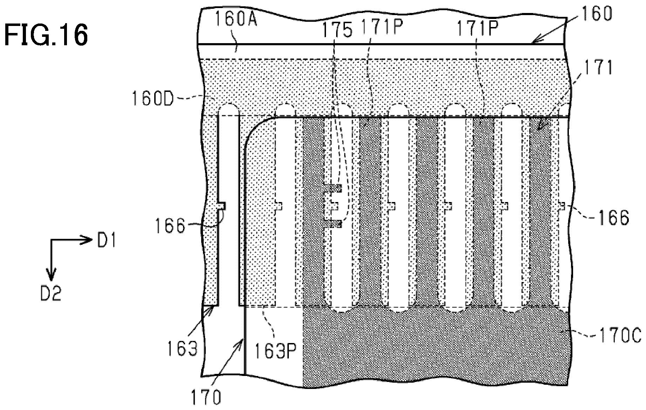

Next, with reference to Fig. 16, the connection between the first tooth terminals 163P and the third tooth terminals 171P will be described. In Fig. 16, the first conductive layer 160D of the first flexible wiring board 160 is indicated by thin halftone dots and the conductive layer 170C is indicated by thick halftone dots. Since the second tooth terminals 164P and the fourth tooth terminals 172P have the same configuration as that of the first tooth terminals 163P and the third tooth terminals 171P, the detailed description thereof will be omitted.

Each of the third tooth terminals 171P overlaps and is electrically connected to corresponding one of the plurality of first tooth terminals 163P. In the third tooth terminal 171P located on each end in the first direction D1, the first projection 166 of the first tooth terminal 163P is positioned between two second projections 175 in the second direction D2. At the same time, in the first direction D1, the tips of the two second projections 175 are located between adjacent first tooth terminals 163P and between the first projection 166 and the side edge of the first tooth terminal 163P closest to the first projection 166. In other words, the first projection 166 is located inside a recess formed by the side edge of the third tooth terminal 171P and two second projections 175.

When the first projection 166 is located inside a recess formed by the side edge of the third tooth terminal 171P and two second projections 175, the first tooth terminals 163P are arranged in appropriate positions relative to the third tooth terminals 171P in each of the first direction D1 and the second direction D2. That is, based on the relative positioning of the first projection 166 and the two second projections 175, the third tooth terminals 171P can be arranged in appropriate positions relative to the first tooth terminals 163P in each of the first direction D1 and the second direction D2.

The positioning using the first projection 166 and the second projection 175 is performed in the third tooth terminal 171P located on each end in the first direction D1 among the plurality of third tooth terminals 171P. This makes it possible to arrange each of the third tooth terminals 171P of the third relay terminal 171 in an appropriate position relative to the first tooth terminal 163P to which it is connected. Furthermore, the first projection 166 is provided in each of the first tooth terminals 163P. Therefore, regardless of which of the first tooth terminals 163P the third tooth terminal 171P having two second projections 175 is connected to, the two second projections 175 can be arranged in appropriate positions relative to the first projection 166, and thus the third tooth terminals 171P can be arranged in appropriate positions relative to the first tooth terminals 163P.

### [Advantageous Effects of Second Embodiment]

According to the second embodiment, the advantageous effects listed below can be achieved in addition to the above advantageous effect (1-1).

(2-1) In the flexible wiring board unit 150, the arrangement of the second flexible wiring board 170 relative to the first flexible wiring board 160 in the first direction D1 can be varied for each pitch P1. For example, in the flexible wiring board 330 shown in Fig. 30, the position at which the second portion 332 extends from the first portion 331 is determined according to the wiring path from the light control sheet 300 to the external power supply 340. If the position at which the second portion 332 extends from the first portion 331 is different, it is required to produce the entire flexible wiring board 330 as a new flexible wiring board with a different shape even if the first portion 331 and the second portion 332 each have the same shape. In this regard, according to the flexible wiring board unit 150 of the second embodiment, a plurality of types of wiring paths can be produced by changing the arrangement of the second flexible wiring board 170 relative to the first flexible wiring board 160.
(2-2) In the first flexible wiring board 160, the first relay terminal 163 and the second relay terminal 164 face the same direction, and in the second flexible wiring board 170, the third relay terminal 171 and the fourth relay terminal 172 face the same direction. Accordingly, the connection between the first relay terminal 163 and the third relay terminal 171 and the connection between the second relay terminal 164 and the fourth relay terminal 172 can be simultaneously performed. Therefore, the first flexible wiring board 160 and the second flexible wiring board 170 can be efficiently connected.
(2-3) In the first flexible wiring board 160, the second bonding terminal 162 faces the direction opposite to that in which the first bonding terminal 161, the first relay terminal 163 and the second relay terminal 164 face. Further, in the second flexible wiring board 170, the third relay terminal 171, the fourth relay terminal 172, the first power supply terminal 173P and the second power supply terminal 174P face the same direction. With this configuration, even when the first bonding terminal 161 and the second bonding terminal 162 are required to face opposite directions, the layer configuration of the second flexible wiring board 170 can be simplified. As a result, the bending resistance and flexibility of the second flexible wiring board 170 can be improved.
(2-4) Since the first projection 166 is provided on each of the first tooth terminals 163P, the third tooth terminals 171P can be arranged in appropriate positions relative to the first tooth terminals 163P, regardless of which of the first tooth terminals 163P the third tooth terminal 171P having the second projections 175 is connected to. Similarly, since the first projection 166 is provided on each of the second tooth terminals 164P, the fourth tooth terminals 172P can be arranged in appropriate positions relative to the second tooth terminals 164P, regardless of which of the second tooth terminals 164P the fourth tooth terminal 172P having the second projections 175 is connected to.

### [Modifications of Second Embodiment]

The second embodiment can be modified and implemented as follows. The modifications described below can be combined with each other as long as no technical contradiction occurs.

- The reference portion included in each of the first tooth terminals 163P and each of the second tooth terminals 164P is not limited to the first projection 166. Similarly, the registration portion included in the third tooth terminal 171P located on each end in the first direction D1 among the plurality of third tooth terminals 171P and the fourth tooth terminal 172P located on each end in the first direction D1 among the plurality of fourth tooth terminals 172P is not limited to two second projections 175. The reference portion and the registration portion may have any shape as long as the third tooth terminals 171P can be arranged in appropriate positions relative to the first tooth terminals 163P or the fourth tooth terminals 172P can be arranged in appropriate positions relative to the second tooth terminals 164P, based on the positioning of the registration portion relative to the reference portion.
- For example, if high precision is not required for positioning of the third tooth terminals 171P relative to the first tooth terminals 163P, the first projection 166 may be provided on each of the first tooth terminals 163P and may not necessarily be provided on each of the second tooth terminals 164P. In this case, the second projection 175 may be provided only on the third tooth terminals 171P, and may not necessarily be provided on the fourth tooth terminals 172P. Similarly, if high precision is not required for positioning of the fourth tooth terminals 172P relative to the second tooth terminals 164P, the first projection 166 may be provided on each of the second tooth terminals 164P and may not necessarily be provided on each of the first tooth terminals 163P. In this case, the second projection 175 may be provided only on the fourth tooth terminals 172P, and may not necessarily be provided on the third tooth terminals 171P. Alternatively, the first projection 166 may not necessarily be provided on each of the first tooth terminals 163P and each of the second tooth terminals 164P, and the second projection 175 may not necessarily be provided on each of the third tooth terminals 171P and each of the fourth tooth terminals 172P.
- For example, in the second flexible wiring board 170, the first power supply terminal 173P and the second power supply terminal 174P may face opposite directions. In this case, a through hole is provided between the third relay terminal 171 and the first power supply terminal 173P or between the fourth relay terminal 172 and the second power supply terminal 174P. This increases the degree of freedom in the form of connection of the first power supply terminal 173P and the second power supply terminal 174P to the external power supply 1A.
- In the first flexible wiring board 160, the first relay terminal 163 and the second relay terminal 164 may face opposite directions. For example, while the first relay terminal 163 and the first bonding terminal 161 face the same direction and the second relay terminal 164 and the second bonding terminal 162 face the same direction, the first bonding terminal 161 and the first relay terminal 163 may face opposite directions. In this case, the first bonding terminal 161 and the first relay terminal 163 are electrically connected via the first conductive layer 160D. Further, the second bonding terminal 162 and the second relay terminal 164 are electrically connected via the second conductive layer 160E. The through hole 165 may not necessarily be provided. In this case, the first relay terminal 163 and the second relay terminal 164 can be arranged in the lamination direction in which the layers forming the first flexible wiring board 160 are arranged. Therefore, the distance of the first flexible wiring board 160 protruding from the light control sheet 10 in the second direction D2 can be reduced. Further, in the second flexible wiring board 170 in this case, the third relay terminal 171 and the fourth relay terminal 172 are arranged such that the third relay terminal 171 and the fourth relay terminal 172 face opposite directions. In this case, the connection between the first relay terminal 163 and the third relay terminal 171 and the connection between the second relay terminal 164 and the fourth relay terminal 172 can be performed separately. Further, in the second flexible wiring board 170, the first power supply terminal 173P and the second power supply terminal 174P may face opposite directions or may face the same direction.
- For example, among the plurality of first tooth terminals 163P, the first tooth terminal 163P that is not connected to the third tooth terminal 171P may be covered with the first outer insulating layer 160A by not removing the first outer insulating layer 160A located on the outer surface side. In other words, among the plurality of first tooth terminals 163P, at least the first tooth terminal 163P that is connected to the third tooth terminal 171P may be exposed from the first outer insulating layer 160A. Covering the first tooth terminal 163P that is not connected to the third tooth terminal 171P with the first outer insulating layer 160A can simplify sealing of the first tooth terminal 163P that is not connected to the third tooth terminals 171P. The same modification can be applied to the second tooth terminal 164P that is not connected to the fourth tooth terminal 172P among the plurality of second tooth terminals 164P.

### [Light Control Unit of Third Embodiment]

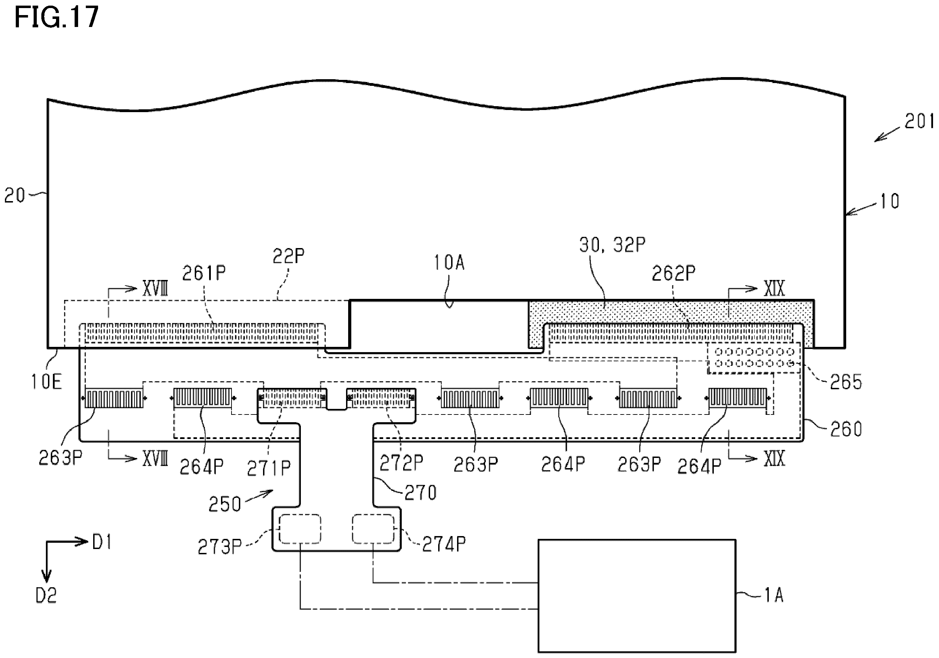

With reference to Figs. 17 to 21, a light control unit of a third embodiment will be described below.

As shown in Fig. 17, a light control unit 201 of the third embodiment includes the same light control sheet 10 as in the first embodiment and a flexible wiring board unit 250. The flexible wiring board unit 250 is connected to the edge 10E of the light control sheet 10.

The flexible wiring board unit 250 includes a first flexible wiring board 260 extending in a first direction D1 and a second flexible wiring board 270 extending in a second direction D2 that intersects the first direction D1. In other words, in the flexible wiring board unit 250, the first flexible wiring board 260 and the second flexible wiring board 270 are electrically connected to each other, the first direction D1 and the second direction D2 mutually intersecting. The first flexible wiring board 260 is responsible for electrical connection to the light control sheet 10, which is a power supply target, in the flexible wiring board unit 250. The second flexible wiring board 270 is responsible for electrical connection to the external power supply 1A in the flexible wiring board unit 250.

Each of the first flexible wiring board 260 and the second flexible wiring board 270 is a flexible printed circuit (FPC). The first flexible wiring board 260 includes a first bonding terminal 261P and a second bonding terminal 262P. The first bonding terminal 261P and the second bonding terminal 262P are arranged in the first direction D1 in the first flexible wiring board 260. The first bonding terminal 261P is disposed on one side of the first flexible wiring board 260 in the first direction D1. The second bonding terminal 262P is disposed on the other side of the first flexible wiring board 260 in the first direction D1. In other words, the first bonding terminal 261P is disposed on a first side of the first flexible wiring board 260 in the first direction D1. The second bonding terminal 262P is disposed on a second side of the first flexible wiring board 260 opposite to the first side in the first direction D1.

The first bonding terminal 261P is located on the second space side of the first electrode terminal 22P (in Fig. 17, rear side of the paper), and faces the first space side (in Fig. 17, front side of the paper). In one example, the first bonding terminal 261P includes a plurality of tooth terminals arranged in a comb-like manner at a predetermined pitch in the first direction D1. The first bonding terminal 261P is bonded and electrically connected to the first electrode terminal 22P while facing the first electrode terminal 22P.

The second bonding terminal 262P is located on the first space side of the second electrode terminal 32P (in Fig. 17, front side of the paper), and faces the second space side (in Fig. 17, rear side of the paper). In one example, the second bonding terminal 262P includes a plurality of tooth terminals arranged in a comb-like manner at a predetermined pitch in the first direction D1. The second bonding terminal 262P is bonded and electrically connected to the second electrode terminal 32P while facing the second electrode terminal 32P.

The first flexible wiring board 260 includes a plurality of first relay terminals 263P and a plurality of second relay terminals 264P. The plurality of first relay terminals 263P and the plurality of second relay terminals 264P are alternately arranged in a row in the first direction D1. The first relay terminals 263P and the second relay terminals 264P face the first space side (in Fig. 17, front side of the paper).

Each of the first relay terminals 263P and each of the second relay terminals 264P includes a plurality of tooth terminals arranged in a comb-like manner at a predetermined pitch in the first direction D1. Each of the first relay terminals 263P and each of the second relay terminals 264P has the same number of tooth terminals arranged at the same pitch. In this example, the number of the first relay terminals 263P is the same as that of the second relay terminals 264P, but the number of the first relay terminals 263P may be greater or smaller than that of the second relay terminals 264P.

Each of the first relay terminals 263P is electrically connected to the first bonding terminal 261P inside the first flexible wiring board 260. Each of the second relay terminals 264P is electrically connected to the second bonding terminal 262P via a plurality of through holes 265 inside the first flexible wiring board 60.

A first side of the second flexible wiring board 270 in the second direction D2 is physically and electrically connected to the first flexible wiring board 260. The second flexible wiring board 270 extends in the second direction D2 from the connection with the first flexible wiring board 260 toward the outside of the light control sheet 10. In one example, the flexible wiring board unit 250 has a substantially T-shaped outline formed of the first flexible wiring board 260 and the second flexible wiring board 270.

The second flexible wiring board 270 includes a third relay terminal 271P and a fourth relay terminal 272P. The third relay terminal 271P and the fourth relay terminal 272P are disposed on the first side of the second flexible wiring board 270 in the second direction D2. The third relay terminal 271P and the fourth relay terminal 272P are arranged in the first direction D1. The third relay terminal 271P and the fourth relay terminal 272P face the second space side (in Fig. 17, rear side of the paper).

The third relay terminal 271P and the fourth relay terminal 272P include a plurality of tooth terminals arranged in a comb-like manner at a predetermined pitch in the first direction D1. The number of tooth terminals and the pitch of tooth terminals included in the third relay terminal 271P and the fourth relay terminal 272P are the same. Further, the number of tooth terminals and the pitch of tooth terminals included in the third relay terminal 271P and the fourth relay terminal 272P are the same as those in each of the first relay terminals 263P and each of the second relay terminals 264P.

The third relay terminal 271P is connected to one of adjacent first relay terminal 263P and second relay terminal 264P among the plurality of first relay terminals 263P and the plurality of second relay terminals 264P arranged in a row. The fourth relay terminal 272P is connected to the other of adjacent first relay terminal 263P and second relay terminal 264P among the plurality of first relay terminals 263P and the plurality of second relay terminals 264P arranged in a row. Accordingly, the first flexible wiring board 260 and the second flexible wiring board 270 are physically and electrically connected.

The second flexible wiring board 270 includes a first power supply terminal 273P and a second power supply terminal 274P. The first power supply terminal 273P and the second power supply terminal 274P are disposed on the second side in the second direction D2 opposite to the first side on which the third relay terminal 271P and the fourth relay terminal 272P are disposed. Each of the first power supply terminal 273P and the second power supply terminal 274P is connected to the external power supply 1A. The external power supply 1A applies a voltage across the first transparent electrode sheet 20 and the second transparent electrode sheet 30 via the flexible wiring board unit 250. This causes the light control sheet 10 to change the light transmittance. The light control sheet 10 is an example power supply target to which the external power supply 1A supplies power via the flexible wiring board unit 250.

### [Cross-Sectional Structure of Light Control Unit of Third Embodiment]

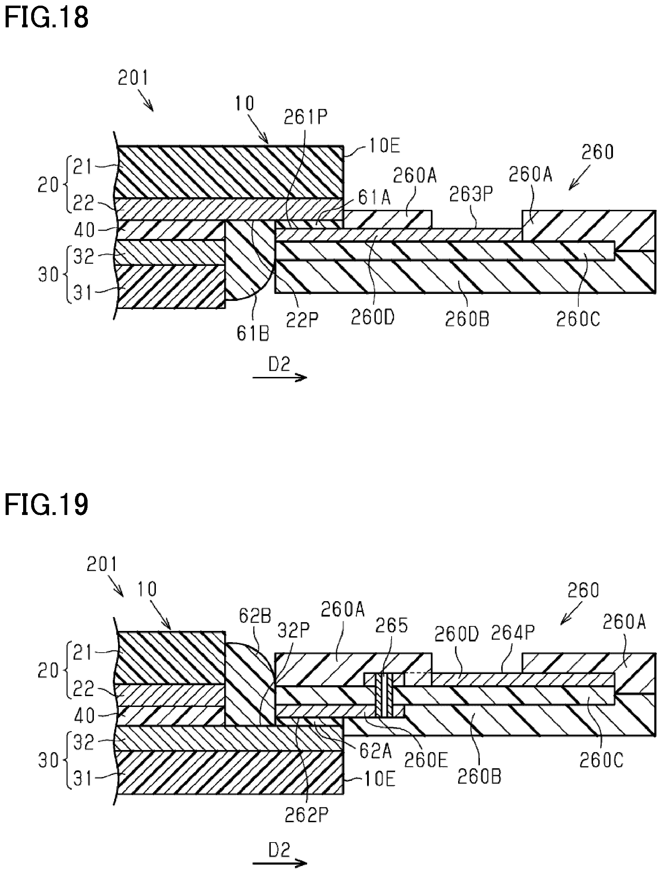

As shown in Figs. 18 and 19, the first flexible wiring board 260 includes a first outer insulating layer 260A, a second outer insulating layer 260B, an inner insulating layer 260C, a first conductive layer 260D and a second conductive layer 260E (see Fig. 19). The inner insulating layer 260C is disposed between the first outer insulating layer 260A and the second outer insulating layer 260B. The first outer insulating layer 260A is located on a side of the inner insulating layer 260C facing the first space partitioned by the light control sheet 10. The second outer insulating layer 260B is located on a side of the inner insulating layer 260C facing the second space partitioned by the light control sheet 10. The first outer insulating layer 260A, the second outer insulating layer 260B and the inner insulating layer 260C are insulating resin films, and may be made of, for example, polyimide.

The first conductive layer 260D is disposed between the first outer insulating layer 260A and the inner insulating layer 260C. The second conductive layer 260E is disposed between the second outer insulating layer 260B and the inner insulating layer 260C. The first conductive layer 260D and the second conductive layer 260E are conductive metal films, and may be made of, for example, copper foil. In the cross-section shown in Fig. 18, the second conductive layer 260E is not disposed. Further, the first conductive layer 260D shown in Fig. 18 is electrically isolated from the first conductive layer 260D shown in Fig. 19. The first flexible wiring board 260 having a double-sided structure includes the first outer insulating layer 260A, the first conductive layer 260D, the inner insulating layer 260C, the second conductive layer 260E and the second outer insulating layer 260B laminated in this order.

As shown in Fig. 18, the first bonding terminal 261P and the first relay terminal 263P are portions of the first flexible wiring board 260 where the first conductive layer 260D is exposed from the first outer insulating layer 260A. The first bonding terminal 261P is electrically connected to the first relay terminal 263P via the first conductive layer 260D inside the first flexible wiring board 260.

The first bonding terminal 261P is electrically conductively bonded to the first electrode terminal 22P via the first conductive adhesive 61A. The first electrode terminal 22P is provided with a first sealing member 61B covering an edge face of the light control layer 40.

As shown in Fig. 19, the second bonding terminal 262P is a portion of the first flexible wiring board 260 where the second conductive layer 260E is exposed from the second outer insulating layer 260B. The second relay terminal 264P is a portion of the first flexible wiring board 260 where the first conductive layer 260D is exposed from the first outer insulating layer 260A. The second conductive layer 260E constituting the second bonding terminal 262P and the first conductive layer 260D constituting the second relay terminal 264P are electrically connected via a through hole 265.

The second bonding terminal 262P of the first flexible wiring board 260 is electrically conductively bonded to the second electrode terminal 32P via the second conductive adhesive 62A. The second electrode terminal 32P is provided with a second sealing member 62B covering an edge face of the light control layer 40.

### [First Flexible Wiring Board of Third Embodiment]

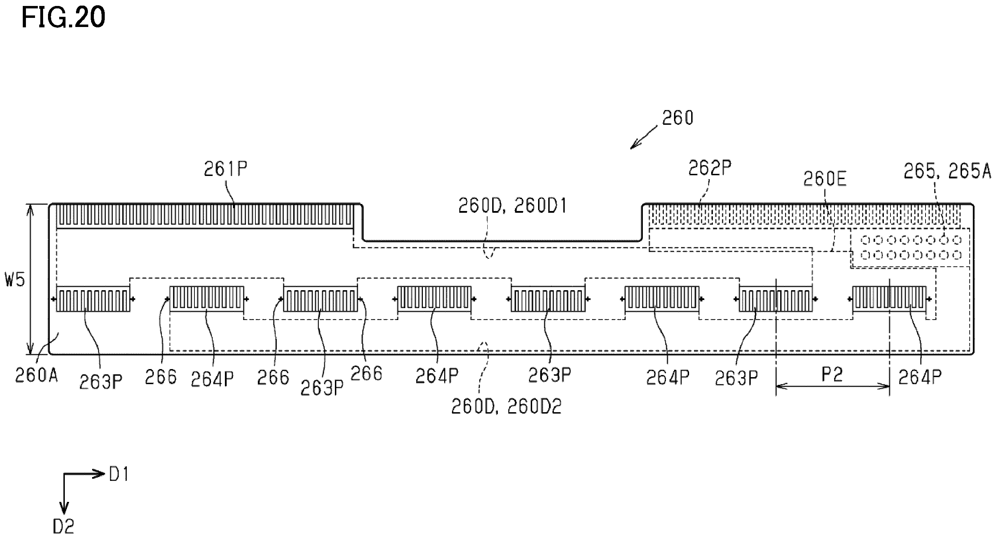

As shown in Fig. 20, the first conductive layer 260D includes a first portion 260D1 and a second portion 260D2. The first portion 260D1 constitutes the first bonding terminal 261P and the first relay terminals 263P of the first conductive layer 260D while connecting the first bonding terminal 261P to each of the first relay terminals 263P. In the first portion 260D1, the first bonding terminal 261P is disposed on one side in the second direction D2 and the respective first relay terminals 263P are disposed on the other side in the second direction D2. The first conductive layer 260D extends in the second direction D2 from the first bonding terminal 261P to each of the first relay terminals 263P.

The second portion 260D2 constitutes the second bonding terminal 262P of the first conductive layer 260D. One side of the second portion 260D2 overlaps the second conductive layer 260E via the inner insulating layer 260C, and is connected to the second conductive layer 260E via a plurality of through holes 265. The plurality of through holes 265 are positioned on the second bonding terminal 262P-side end of the first flexible wiring board 260 in the first direction D1. The plurality of through holes 265 are positioned between the second bonding terminal 262P and each of the second relay terminals 264P in the second direction D2. The number of through holes 265 may be determined according to the magnitude of current flowing through the second portion 260D2 and the second conductive layer 260E, and may be, for example, one or two or more.

The portion where the second portion 260D2 overlaps the second conductive layer 260E via the inner insulating layer 260C and where the plurality of through holes 265 are provided is an example of an interlayer connection section 265A where the first conductive layer 260D is electrically connected to the second conductive layer 260E. In one example, the interlayer connection section 265A is positioned between the second bonding terminal 262P and each of the second relay terminals 264P in the second direction D2. The interlayer connection section 265A is disposed at a position displaced toward the second bonding terminal 262P-side from the center of the first flexible wiring board 260 in the first direction D1. Further, in the first direction D1, the width of the interlayer connection section 265A is smaller than the width of the second bonding terminal 262P.

Since the interlayer connection section 265A is a portion including the through holes 265, it has relatively poor flexibility and low bending resistance compared to the other portions in the first flexible wiring board 260. By reducing the area of the interlayer connection section 265A as in the first embodiment in plan view in a direction perpendicular to the first flexible wiring board 260, a decrease in the flexibility and bending resistance of the first flexible wiring board 260 as a whole can be suppressed. In other words, by concentrating the plurality of through holes 265 in a single location within a small area in plan view in a direction perpendicular to the first flexible wiring board 260, a decrease in the flexibility and bending resistance of the first flexible wiring board 260 as a whole can be suppressed. In particular, in the first direction D1, by making the width of the interlayer connection section 265A smaller than the width of the second bonding terminal 262P and by positioning the interlayer connection section 265A displaced toward the second bonding terminal 262P-side, a decrease in bending resistance against bending in a direction parallel to the first direction D1 can be suppressed.

The second portion 260D2 extends in the second direction D2 from the interlayer connection section 265A toward the side of the first flexible wiring board 260 opposite to that on which the second bonding terminal 262P is disposed. The second portion 260D2 extends between the side edge of the first flexible wiring board 260 extending in the second direction D2 on the second bonding terminal 262P-side and the second relay terminal 264P closest to that side edge. The second portion 260D2 extends in the first direction D1 between the side edge of the first flexible wiring board 260 extending in the first direction D1 on a side opposite to that on which the second bonding terminal 262P is located and the respective second relay terminals 264P, and also extends toward the second bonding terminal 262P-side to form the respective second relay terminals 264P.

The plurality of first relay terminals 263P and the plurality of second relay terminals 64P are alternately arranged at a predetermined pitch P2 in the first direction D1. The first flexible wiring board 260 has a width W5 in the second direction D2. In the first relay terminals 263P, the tips of the tooth terminals having a comb-like shape extend away from the first bonding terminal 261P. In the second relay terminals 264P, the tips of the tooth terminals having a comb-like shape extend toward the second bonding terminal 262P.

Each of the first relay terminals 263P and each of the second relay terminals 264P has a reference portion 266. In one example, each reference portion 266 is provided on both ends of the respective first relay terminals 263P and the respective second relay terminals 264P in the first direction D1. The reference portion 266 may be, for example, a crusiform projection. The reference portion 266 serves as a reference for appropriately arranging the terminals when the third relay terminal 271P or the fourth relay terminal 272P is connected to the first relay terminal 263P or the second relay terminal 264P.

### [Second Flexible Wiring Board of Third Embodiment]

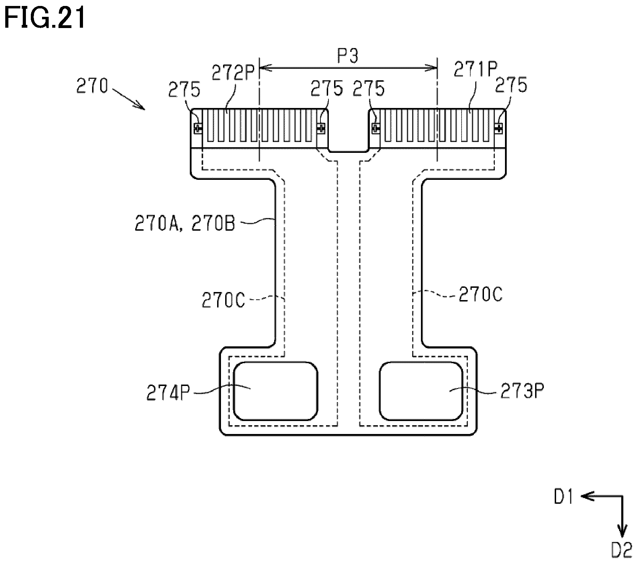

Next, with reference to Fig. 21, the second flexible wiring board 270 will be described. In Fig. 21, the second flexible wiring board 270 has been inverted from the state shown in Fig. 17.

As shown in Fig. 21, the second flexible wiring board 270 includes a third outer insulating layer 270A, a fourth outer insulating layer 270B and a conductive layer 270C. The conductive layer 270C is disposed between the third outer insulating layer 270A and the fourth outer insulating layer 270B. The third outer insulating layer 270Ais located on the first space side of the conductive layer 270C (in Fig. 21, rear side of the paper). The fourth outer insulating layer 270B is located on the second space side of the conductive layer 270C (in Fig. 21, front side of the paper). The third outer insulating layer 270A and the fourth outer insulating layer 270B are insulating resin films, and may be made of, for example, polyimide. The conductive layer 270C is a conductive metal film, and may be made of, for example, copper foil. The second flexible wiring board 270 having a single-sided structure includes the third outer insulating layer 270A, the conductive layer 270C and the fourth outer insulating layer 270B laminated in this order. The second flexible wiring board 270 having a single-sided structure includes fewer layers in the lamination direction than the first flexible wiring board 260 having a double-sided structure does.

The third relay terminal 271P, the fourth relay terminal 272P, the first power supply terminal 273P and the second power supply terminal 274P of the second flexible wiring board 270 are portions of the second flexible wiring board 270 where the conductive layer 270C is exposed from the fourth outer insulating layer 270B. The conductive layer 270C electrically connects the third relay terminal 271P with the first power supply terminal 273P and electrically connects the fourth relay terminal 272P with the second power supply terminal 274P inside the second flexible wiring board 270. Further, in the conductive layer 270C, a portion connecting the third relay terminal 271P with the first power supply terminal 273P is electrically insulated from a portion connecting the fourth relay terminal 272P with the second power supply terminal 274P. In one example, in the first direction D1, a pitch P3 from the center of the third relay terminal 271P to the center of the fourth relay terminal 272P is the same as the pitch P2 at which the first relay terminals 263P and the second relay terminals 264P are arranged.

Each of the third relay terminal 271P and the fourth relay terminal 272P has a registration portion 275. In one example, the registration portion 275 is provided on both ends of the third relay terminal 271P and the fourth relay terminal 272P in the first direction D1. The registration portion 275 may be, for example, a crusiform recess.

When the third relay terminal 271P or the fourth relay terminal 272P are connected to the first relay terminals 263P or the second relay terminals 264P, the reference portion 266 and the registration portion 275 can be combined to appropriately arrange the terminals. For example, when the third relay terminal 271P is connected to the first relay terminals 263P, the projection of the reference portion 266 is positioned inside the recess of the registration portion 275 so that the third relay terminal 271P is appropriately arranged relative to the first relay terminals 263P. That is, in a plane including the first direction D1 and the second direction D2, the third relay terminal 271P and the fourth relay terminal 272P can be appropriately arranged relative to the first relay terminal 263P or the second relay terminal 264P based on the arrangement of the registration portion 275 relative to the reference portion 266.

In the first flexible wiring board 260, the second bonding terminal 262P is disposed to face the direction opposite to that in which the first bonding terminal 261P, the first relay terminal 263P and the second relay terminal 264P face due to the three insulating layers 260A to 260C and two conductive layers 260D and 260E. On the other hand, in the second flexible wiring board 270, the third relay terminal 271P, the fourth relay terminal 272P, the first power supply terminal 273P and the second power supply terminal 274P are disposed to face the same direction due to the two insulating layers 270A and 270B and one conductive layer 270C. Even when the first bonding terminal 261P and the second bonding terminal 262P are required to face opposite directions, the layer configuration of the second flexible wiring board 270 can be simplified. As a result, the bending resistance and flexibility of the second flexible wiring board 270 can be improved due to the fewer constituent layers.

### [Connection between First Flexible Wiring Board and Second Flexible Wiring Board of Third Embodiment]

The third relay terminal 271P is connected to corresponding one of the plurality of first relay terminals 263P or corresponding one of the plurality of second relay terminals 264P. The fourth relay terminal 272P is connected to the other of the plurality of first relay terminals 263P and the plurality of second relay terminals 264P in the other of the first relay terminal 263P and second relay terminal 264P, respectively, which is the relay terminal adjacent to the relay terminal to which the third relay terminal 271P is connected.

For example, when the third relay terminal 271P is connected to the first relay terminal 263P, the fourth relay terminal 272P is connected to the second relay terminal 264P adjacent to the first relay terminal 263P to which the third relay terminal 271P is connected. For example, when the third relay terminal 271P is connected to the second relay terminal 264P, the fourth relay terminal 272P is connected to the first relay terminal 263P adjacent to the second relay terminal 264P to which the third relay terminal 271P is connected.

That is, when the third relay terminal 271P is electrically connected to one of the first relay terminal 263P and the second relay terminal 264P, the fourth relay terminal 272P is electrically connected to the other of the first relay terminal 263P and the second relay terminal 264P. In the second flexible wiring board 270, the fourth relay terminal 272P is disposed relative to the third relay terminal 271P in a plane including the first direction D1 and the second direction D2 so that the above connection can be performed.

In the flexible wiring board unit 250, the arrangement of the third relay terminal 271P and the fourth relay terminal 272P relative to the terminal row formed of the plurality of first relay terminals 263P and the plurality of second relay terminals 264P can be varied. Accordingly, in the flexible wiring board unit 250, the arrangement of the second flexible wiring board 270 relative to the first flexible wiring board 260 in the first direction D1 can be varied for each pitch P2.

For the connection of the first relay terminal 263P and the second relay terminal 264P to the third relay terminal 271P and the fourth relay terminal 272P, for example, an adhesive made of at least one selected from the group consisting of an anisotropic conductive film, an anisotropic conductive paste, an isotropic conductive film and an isotropic conductive paste is used.

The first flexible wiring board 260 and the second flexible wiring board 270 are integrally connected by the connection between one of the plurality of first relay terminals 263P and one of the plurality of second relay terminals 264P to the third relay terminal 271P and the fourth relay terminal 272P. The first relay terminals 263P and the second relay terminals 264P face the same direction, and the third relay terminal 271P and the fourth relay terminal 272P face the same direction. Therefore, the connection between the third relay terminal 271P and one of the first relay terminal 263P and the second relay terminal 264P and the connection between the fourth relay terminal 272P and the other of the first relay terminal 263P and the second relay terminal 264P can be simultaneously performed.

In addition, the first relay terminal 263P and the second relay terminal 264P that are not connected to either the third relay terminal 271P or the fourth relay terminal 272P may be sealed by, for example, applying and curing an insulating resin paste.

Next, the circuit configuration of the flexible wiring board unit 250 will be described. First, a description will be given of a case where the third relay terminal 271P is connected to the first relay terminal 263P, and the fourth relay terminal 272P is connected to the second relay terminal 264P. In this case, the first bonding terminal 261P is electrically connected to the external power supply 1A via the first relay terminal 263P, the third relay terminal 271P and the first power supply terminal 273P. The second bonding terminal 262P is electrically connected to the external power supply 1A via the second relay terminal 264P, the fourth relay terminal 272P and the second power supply terminal 274P.

Next, a description will be given of a case where the third relay terminal 271P is connected to the second relay terminal 264P, and the fourth relay terminal 272P is connected to the first relay terminal 263P. In this case, the first bonding terminal 261P is electrically connected to the external power supply 1A via the first relay terminal 263P, the fourth relay terminal 272P and the second power supply terminal 274P. The second bonding terminal 262P is electrically connected to the external power supply 1Avia the second relay terminal 264P, the third relay terminal 271P and the first power supply terminal 273P.

### [Advantageous Effects of Third Embodiment]

According to the third embodiment, the advantageous effects listed below can be achieved in addition to the above advantageous effect (1-1).

(3-1) In the flexible wiring board unit 250, the arrangement of the second flexible wiring board 270 relative to the first flexible wiring board 260 in the first direction D1 can be varied for each pitch P2. For example, in the flexible wiring board 330 shown in Fig. 30, the position at which the second portion 332 extends from the first portion 331 is determined according to the wiring path from the light control sheet 300 to the external power supply 340. If the position at which the second portion 332 extends from the first portion 331 is different, it is required to produce the entire flexible wiring board 330 as a new flexible wiring board with a different shape even if the first portion 331 and the second portion 332 each have the same shape. In this regard, according to the flexible wiring board unit 250 of the third embodiment, a plurality of types of wiring paths can be produced by changing the arrangement of the second flexible wiring board 270 relative to the first flexible wiring board 260.
(3-2) In the first flexible wiring board 260, the first relay terminal 263P and the second relay terminal 264P face the same direction, and in the second flexible wiring board 270, the third relay terminal 271P and the fourth relay terminal 272P face the same direction. Accordingly, the connection between the third relay terminal 271P and one of the first relay terminal 263P and the second relay terminal 264P and the connection between the fourth relay terminal 272P and the other of the first relay terminal 263P and the second relay terminal 264P can be simultaneously performed. Therefore, the first flexible wiring board 260 and the second flexible wiring board 270 can be efficiently connected.
(3-3) In the first flexible wiring board 260, the second bonding terminal 262P faces the direction opposite to that in which the first bonding terminal 261P, the first relay terminal 263P and the second relay terminal 264P face. Further, in the second flexible wiring board 270, the third relay terminal 271P, the fourth relay terminal 272P, the first power supply terminal 273P and the second power supply terminal 274P face the same direction. Accordingly, even when the first bonding terminal 261P and the second bonding terminal 262P are required to face opposite directions, the layer configuration of the second flexible wiring board 270 can be simplified. As a result, the bending resistance and flexibility of the second flexible wiring board 270 can be improved.
(3-4) In the first direction D1, the width of the interlayer connection section 265A is made smaller than the width of the second bonding terminal 262P, and the interlayer connection section 265A is displaced toward the second bonding terminal 262P from the center of the first flexible wiring board 260. Accordingly, a decrease in bending resistance of the first flexible wiring board 260 against bending in a direction parallel to the first direction D1 can be suppressed.
(3-5) Each of the first relay terminals 263P and each of the second relay terminals 264P has the reference portion 266. Therefore, regardless of whether each of the third relay terminal 271P and the fourth relay terminal 272P is connected to either the first relay terminal 263P or the second relay terminal 264P, the two connected relay terminals can be appropriately positioned based on the arrangement of the registration portion 275 relative to the reference portion 266.

### [Fourth Embodiment]

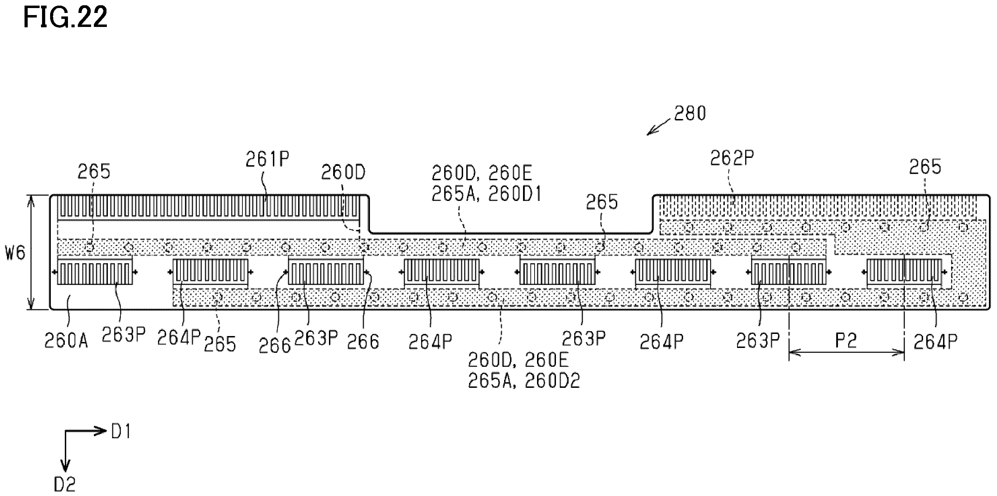

With reference to Fig. 22, a light control unit of a fourth embodiment will be described below. Alight control unit of the fourth embodiment has the same configuration as that of the light control unit 201 of the third embodiment except that a first flexible wiring board 280 is provided instead of the first flexible wiring board 260.

As shown in Fig. 22, the first flexible wiring board 280 includes, as with the first flexible wiring board 260, the first bonding terminal 261P, the second bonding terminal 262P, a plurality of first relay terminals 263P and a plurality of second relay terminals 264P. The first bonding terminal 261P, the first relay terminals 263P and the second relay terminals 264P are formed of the first conductive layer 260D. The second bonding terminal 262P is formed of the second conductive layer 260E.

The second conductive layer 260E is connected to the first portion 260D1 that connects the first bonding terminal 261P and the first relay terminals 263P via a plurality of through holes 265. That is, between the first bonding terminal 261P and the first relay terminals 263P, the interlayer connection section 265A is provided in which the first conductive layer 260D and the second conductive layer 260E are electrically connected via a plurality of through holes 265. In Fig. 22, the interlayer connection section 265A is indicated by the dots.

The interlayer connection section 265A positioned between the first bonding terminal 261P and the first relay terminals 263P extends in the first direction D1 from one end to the other end of a terminal row formed of the plurality of first relay terminals 263P. The interlayer connection section 265A positioned between the first bonding terminal 261P and the first relay terminals 263P includes one or more through holes 265 at positions, for example, at least adjacent to each of the first relay terminals 263P.

In the first portion 260D1 that connects the first bonding terminal 261P and the first relay terminals 263P, the width in the second direction D2 of a portion formed as the interlayer connection section 265A is smaller than the width of a portion formed only of the first conductive layer 260D.

In the second conductive layer 260E constituting the second bonding terminal 262P and the second portion 260D2 constituting the second relay terminals 264P, the portions other than the second bonding terminal 262P and the second relay terminals 264P are electrically connected via a plurality of through holes 265. That is, between the second bonding terminal 62P and the second relay terminals 264P, the interlayer connection section 265A is provided in which the first conductive layer 260D and the second conductive layer 260E are electrically connected via a plurality of through holes 265. The interlayer connection section 265A that connects the second bonding terminal 262P and the second relay terminals 264P includes one or more through holes 265 at positions, for example, at least adjacent to each of the first relay terminals 263P.

In the interlayer connection section 265A that connects the second bonding terminal 262P and the second relay terminals 264P, the width in the second direction D2 of a portion located on a side of the second relay terminals 264P opposite to that on which the second bonding terminal 262P is located is smaller than the width of a portion formed only of the first conductive layer 260D.

In the first flexible wiring board 280, the interlayer connection section 265A connects the first bonding terminal 261P and the first relay terminals 263P and connects the second bonding terminal 262P and the second relay terminals 264P. In the interlayer connection section 265A, current branches into the first conductive layer 260D and the second conductive layer 260E. Therefore, even when the width of the interlayer connection section 265A in the second direction D2 is reduced, heat generation due to current flow is unlikely to occur.

In other words, due to the interlayer connection section 265A connecting the first bonding terminal 261P and the first relay terminals 263P, a width W6 of the first flexible wiring board 280 in the second direction D2 can be made smaller than the width W5 of the first flexible wiring board 260 while suppressing an increase in the amount of heat generation due to current flow. Similarly, due to the interlayer connection section 265A connecting the second bonding terminal 262P and the second relay terminals 264P, the width W6 of the first flexible wiring board 280 can be made smaller than the width W5 of the first flexible wiring board 60 while suppressing heat generation due to current flow.

In addition, the interlayer connection section 265A between the second bonding terminal 262P and the second relay terminals 264P may be disposed at least on a side of the second relay terminals 264P opposite to that on which the second bonding terminal 262P is located (in Fig. 22, right side of the paper relative to the second bonding terminal 262P). Further, the interlayer connection section 265A may extend in the first direction D1 from one end to the other end of the terminal row formed of the plurality of second relay terminals 264P.

### [Advantageous Effects of Fourth Embodiment]

According to the fourth embodiment, the advantageous effects described below can be achieved.

(4-1) Due to the interlayer connection section 265A connecting the first bonding terminal 261P and the first relay terminals 263P, the width W6 of the first flexible wiring board 280 can be made smaller than the width W5 of the first flexible wiring board 260 while suppressing an increase in the amount of heat generation due to current flow. Similarly, due to the interlayer connection section 265A connecting the second bonding terminal 262P and the second relay terminals 264P, the width W6 of the first flexible wiring board 280 can be made smaller than the width W5 of the first flexible wiring board 260 while suppressing heat generation due to current flow. Therefore, while the flexible wiring board unit 250 is connected to the light control sheet 10, the length of the first flexible wiring board 280 protruding from the light control sheet 10 can be reduced. Further, the flexible wiring board unit 250 including the first flexible wiring board 280 can also achieve the advantageous effects similar to the above (1-1), (3-1) to (3-3) and (3-5).

### [Fifth Embodiment]

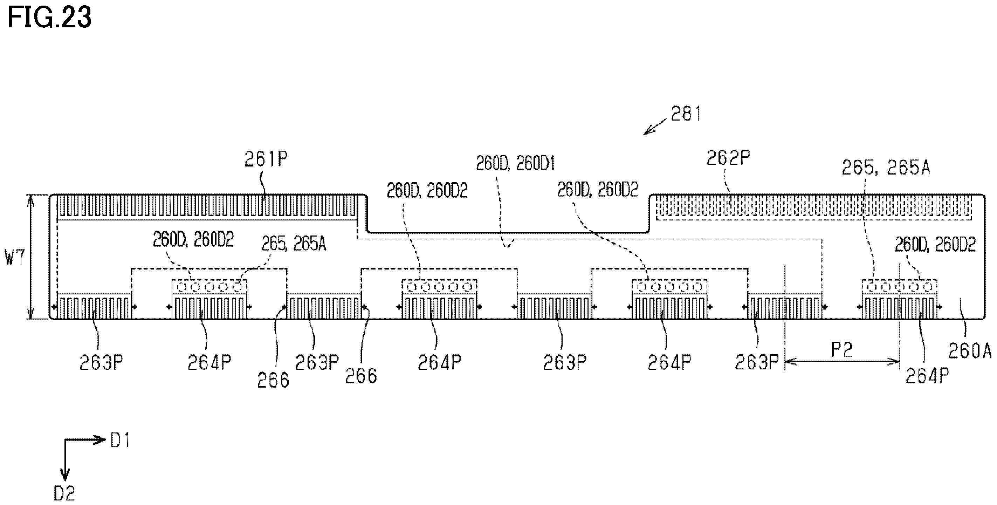

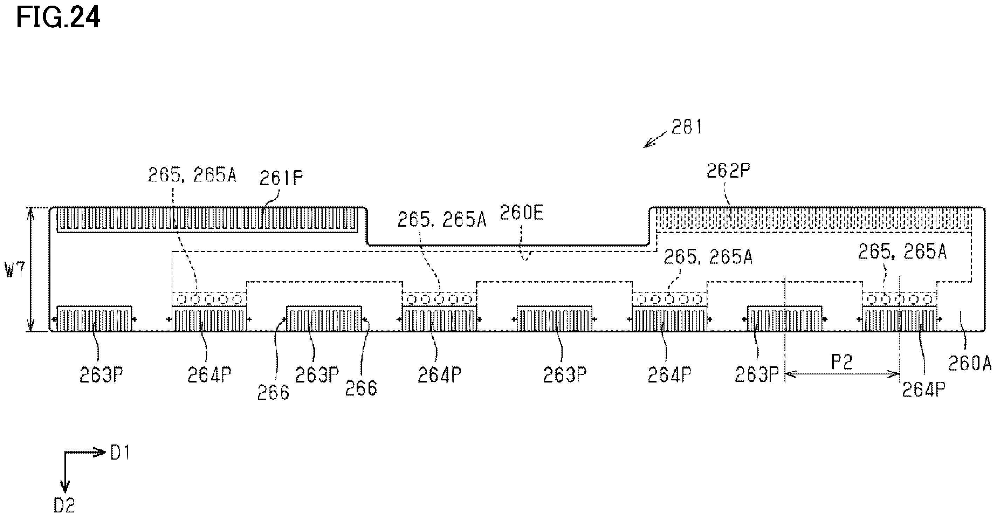

With reference to Figs. 23 and 24, a light control unit of a fifth embodiment will be described below. A light control unit of the fifth embodiment has the same configuration as that of the light control unit 201 of the third embodiment except that a first flexible wiring board 281 is provided instead of the first flexible wiring board 260.

As shown in Fig. 23, the first flexible wiring board 281 includes, as with the first flexible wiring board 260, the first bonding terminal 261P, the second bonding terminal 262P, a plurality of first relay terminals 263P and a plurality of second relay terminals 264P. The first relay terminals 263P and the second relay terminals 264P are disposed on the second side of the first flexible wiring board 281 in the second direction D2 opposite to the first side on which the first bonding terminal 261P and the second bonding terminal 262P are disposed. Further, in the first relay terminals 263P and the second relay terminals 264P, the tips of the tooth terminals having a comb-like shape extend away from the first bonding terminal 261P and the second bonding terminal 262P.

The first bonding terminal 261P, the first relay terminals 263P and the second relay terminals 264P are formed of the first conductive layer 260D. The second bonding terminal 262P is formed of the second conductive layer 260E. In Fig. 23, the outline of a portion of the first conductive layer 260D overlapping the first outer insulating layer 260A is indicated by the dotted line.

In the first portion 260D1 that connects the first bonding terminal 261P and the first relay terminals 263P, the first bonding terminal 261P is disposed on one side in the second direction D2 and the respective first relay terminals 263P are disposed on the other side in the second direction D2. The first conductive layer 260D extends in the second direction D2 from the first bonding terminal 261P to each of the first relay terminals 263P.

The second portions 260D2 constituting the second relay terminals 264P are discontinuously disposed. In other words, the second portions 260D2 are provided in the same number as the number of the second relay terminals 264P. Each of the second portions 260D2 extends in the second direction D2 from the second relay terminal 264P toward the second bonding terminal 262P.

As shown in Fig. 24, in the second conductive layer 260E constituting the second bonding terminal 262P, the second bonding terminal 262P is disposed on one side in the second direction D2 and the other side in the second direction D2 overlaps each of the second portions 260D2 constituting the second relay terminals 264P. In Fig. 24, the outline of the second conductive layer 260E is indicated by the dotted line.

The portions where the second conductive layer 260E overlaps each of the second portions 260D2 constitute the interlayer connection sections 265A in which the second conductive layer 260E is electrically connected to each of the second portions 260D2 via a plurality of through holes 265. That is, in the first flexible wiring board 281, the interlayer connection section 265A is provided for each of the second relay terminals 264P. In the first flexible wiring board 281, the second relay terminal 264P and the interlayer connection section 265A are arranged side by side in the second direction D2 such that the interlayer connection sections 265A are located on the second bonding terminal 262P-side of the second relay terminals 264P.

The portions of the second conductive layer 260E connecting the second bonding terminal 262P and each of the interlayer connection sections 265A overlap the portions of the first portion 260D1 connecting the first bonding terminal 261P and each of the first relay terminals 263P via the inner insulating layer 260C. The second conductive layer 260E connecting the second bonding terminal 262P and each of the second relay terminals 264P and the second portions 260D2 are positioned between the second bonding terminal 262P and each of the second relay terminals 264P in the second direction D2.

According to the above arrangement of the first conductive layer 260D and the second conductive layer 260E, the first relay terminals 263P and the second relay terminals 264P can be disposed on one side (edge) of the first flexible wiring board 281 in the second direction D2. In this case, compared with the first flexible wiring board 260 of the third embodiment, the wiring path connecting the second bonding terminal 262P and each of the second relay terminals 264P can be made shorter. As a result, a width W7 of the first flexible wiring board 281 in the second direction D2 can be made smaller than the width W5 of the first flexible wiring board 260.

### [Advantageous Effects of Fifth Embodiment]

According to the fifth embodiment, the advantageous effects described below can be achieved.

(5-1) By providing the interlayer connection section 265A for each of the second relay terminals 264P, the width W7 of the first flexible wiring board 281 in the second direction D2 can be made smaller than the width W5 of the first flexible wiring board 260. As a result, while the flexible wiring board unit 250 is connected to the light control sheet 10, the length of the first flexible wiring board 281 protruding from the light control sheet 10 can be reduced. Further, the flexible wiring board unit 250 including the first flexible wiring board 281 can also achieve the advantageous effects similar to the above (1-1), (3-1) to (3-3) and (3-5).

### [Sixth Embodiment]

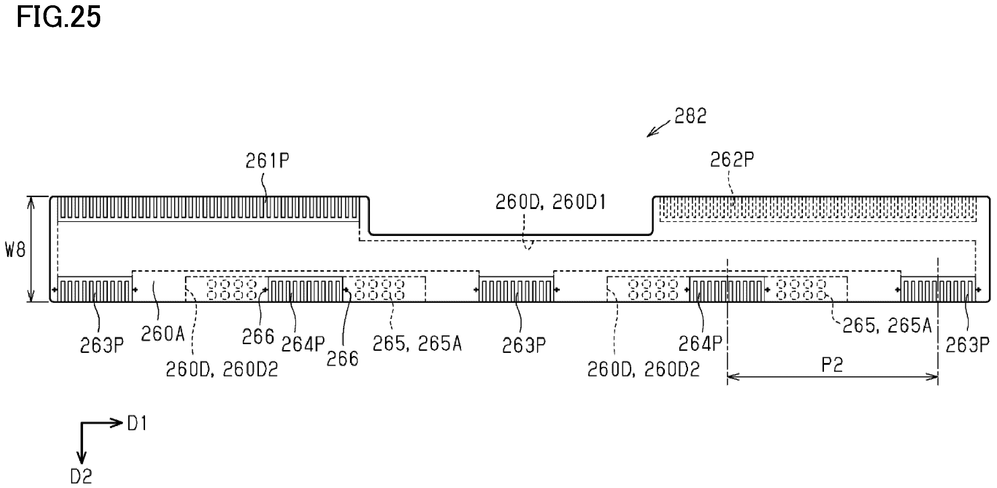

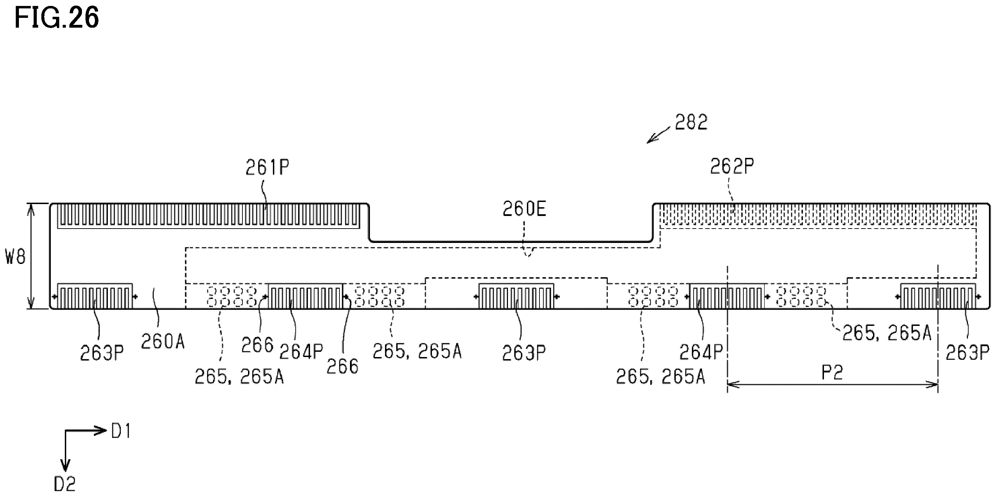

With reference to Figs. 25 and 26, a light control unit of a sixth embodiment will be described below. A light control unit of the sixth embodiment has the same configuration as that of the light control unit 201 of the third embodiment except that a first flexible wiring board 282 is provided instead of the first flexible wiring board 260.

As shown in Fig. 25, the first flexible wiring board 282 includes, as with the first flexible wiring board 260, the first bonding terminal 261P, the second bonding terminal 262P, a plurality of first relay terminals 263P and a plurality of second relay terminals 264P.

The first relay terminals 263P and the second relay terminals 264P are disposed on the second side of the first flexible wiring board 282 in the second direction D2 opposite to the first side on which the first bonding terminal 261P and the second bonding terminal 262P are disposed. Further, in the first relay terminals 263P and the second relay terminals 264P, the tips of the tooth terminals having a comb-like shape extend away from the first bonding terminal 261P and the second bonding terminal 262P. In the first flexible wiring board 282 of the sixth embodiment, the pitch P2 at which the first relay terminals 263P and the second relay terminals 264P are alternately arranged is greater than the pitch P2 in the first flexible wiring board 260 of the third embodiment. Therefore, in the second flexible wiring board 270 of the sixth embodiment, the pitch P3 from the center of the third relay terminal 271P to the center of the fourth relay terminal 272P is greater than that in the third embodiment.

The first bonding terminal 261P, the first relay terminals 263P and the second relay terminals 264P are formed of the first conductive layer 260D. The second bonding terminal 262P is formed of the second conductive layer 260E. In Fig. 25, the outline of a portion of the first conductive layer 260D overlapping the first outer insulating layer 260A is indicated by the dotted line.

In the first portion 260D1 that connects the first bonding terminal 261P and the first relay terminals 263P, the first bonding terminal 261P is disposed on one side in the second direction D2 and the respective first relay terminals 263P are disposed on the other side in the second direction D2. The first conductive layer 260D extends in the second direction D2 from the first bonding terminal 261P to each of the first relay terminals 263P.

The second portions 260D2 constituting the second relay terminals 264P are discontinuously disposed. In other words, the second portions 260D2 are provided in the same number as the number of the second relay terminals 264P. Each of the second portions 260D2 extends in the first direction D1 from the second relay terminal 264P to the first relay terminals 263P located on both sides of the second relay terminal 264P.

As shown in Fig. 26, in the second conductive layer 260E constituting the second bonding terminal 262P, the second bonding terminal 262P is disposed on one side in the second direction D2 and the other side in the second direction D2 overlaps each of the second portions 260D2 constituting the second relay terminals 264P. In Fig. 26, the outline of the second conductive layer 260E is indicated by the dotted line.

The portions where the second conductive layer 260E overlaps each of the second portions 260D2 constitute the interlayer connection sections 265A in which the second conductive layer 260E is electrically connected to each of the second portions 260D2 via a plurality of through holes 265. That is, in the first flexible wiring board 282, the interlayer connection section 265A is provided for each of the second relay terminals 264P. Each of the interlayer connection sections 265A is disposed on both sides of each of the second relay terminals 264P in the first direction D1. In one example, the interlayer connection sections 265A are disposed on both sides of the second relay terminal 264P between two first relay terminals 263P. The interlayer connection sections 265A may be disposed adjacent to at least one side of each of the second relay terminals 264P in the first direction D1.

The portions of the second conductive layer 260E connecting the second bonding terminal 262P and each of the interlayer connection sections 265A overlap the portions of the first portion 260D1 connecting the first bonding terminal 261P and each of the first relay terminals 263P via the inner insulating layer 260C.

According to the above arrangement of the first conductive layer 260D and the second conductive layer 260E, the first relay terminals 263P and the second relay terminals 264P can be disposed on one side of the first flexible wiring board 282 in the second direction D2. In this case, compared with the first flexible wiring board 260 of the third embodiment, the wiring path connecting the second bonding terminal 262P and each of the second relay terminals 264P can be made shorter. As a result, a width W8 of the first flexible wiring board 282 in the second direction D2 can be made smaller than the width W5 of the first flexible wiring board 260.

Further, in the first flexible wiring board 282 of the sixth embodiment, the second relay terminals 264P and the interlayer connection sections 265A are arranged side by side in the first direction D1. Therefore, compared to the first flexible wiring board 281 of the fifth embodiment, the width W8 can be made smaller than the width W7 due to the absence of the interlayer connection section 265A between the second bonding terminal 262P and the second relay terminal 264P in the second direction D2.

In addition, in the first flexible wiring board 281 of the fifth embodiment, compared to the first flexible wiring board 282 of the sixth embodiment, the pitch P2 can be made smaller due to the absence of the interlayer connection section 265A between the first relay terminal 263P and the second relay terminal 264P. Therefore, in the first direction D1, the arrangement of the second flexible wiring board 270 relative to the first flexible wiring board 281 can be varied at shorter intervals.

### [Advantageous Effects of Sixth Embodiment]

According to the sixth embodiment, the advantageous effects described below can be achieved.
(6-1) By providing the interlayer connection section 265A for each of the second relay terminals 264P, the width W8 of the first flexible wiring board 282 in the second direction D2 can be made smaller than the width W5 of the first flexible wiring board 260. As a result, while the flexible wiring board unit 250 is connected to the light control sheet 10, the length of the first flexible wiring board 282 protruding from the light control sheet 10 can be reduced. Further, the flexible wiring board unit 250 including the first flexible wiring board 282 can also achieve the advantageous effects similar to the above (1-1), (3-1) to (3-3) and (3-5).
(6-1) By arranging the second relay terminals 264P and the interlayer connection sections 265A side by side in the first direction D1, the width W4 of the first flexible wiring board 282 in the second direction D2 can be made smaller than the width W3 of the first flexible wiring board 281.

### [Seventh Embodiment]

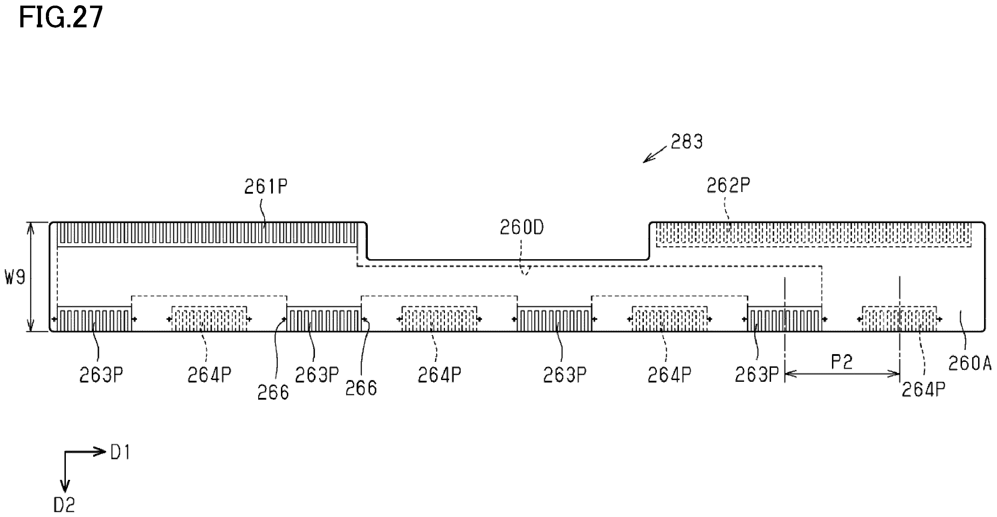

With reference to Figs. 27 to 29, a light control unit of a seventh embodiment will be described below. A light control unit of the seventh embodiment has the same configuration as that of the light control unit 201 of the third embodiment except that a first flexible wiring board 283 and a second flexible wiring board 290 are provided instead of the first flexible wiring board 260 and the second flexible wiring board 270.

As shown in Fig. 27, the first flexible wiring board 283 includes the first bonding terminal 261P, the second bonding terminal 262P, a plurality of first relay terminals 263P and a plurality of second relay terminals 264P. The first bonding terminal 261P and the plurality of first relay terminals 263P face the first space partitioned by the light control sheet 10 (in Fig. 27, front side of the paper). The second bonding terminal 262P and the plurality of second relay terminals 264P face the second space partitioned by the light control sheet 10 (in Fig. 27, rear side of the paper). Therefore, the first relay terminals 263P and the second relay terminals 264P face opposite directions.

The first bonding terminal 261P and the first relay terminals 263P are formed of the first conductive layer 260D. In Fig. 27, the outline of a portion of the first conductive layer 260D overlapping the first outer insulating layer 260A is indicated by the dotted line. The second bonding terminal 262P and the second relay terminals 264P are formed of the second conductive layer 260E. The second bonding terminal 262P and the second relay terminals 264P are portions where the second conductive layer 260E is exposed from the second outer insulating layer 260B to the second space.

Each of the first relay terminals 263P and each of the second relay terminals 264P are disposed on the second side of the first flexible wiring board 283 in the second direction D2 opposite to the first side on which the first bonding terminal 261P and the second bonding terminal 262P are disposed. Further, in the first relay terminals 263P and the second relay terminals 264P, the tips of the tooth terminals having a comb-like shape extend away from the first bonding terminal 261P and the second bonding terminal 262P.

In the first conductive layer 260D, the first bonding terminal 261P is disposed on one side in the second direction D2 and the respective first relay terminals 263P are disposed on the other side in the second direction D2. The first conductive layer 260D extends in the second direction D2 from the first bonding terminal 261P to each of the first relay terminals 263P.

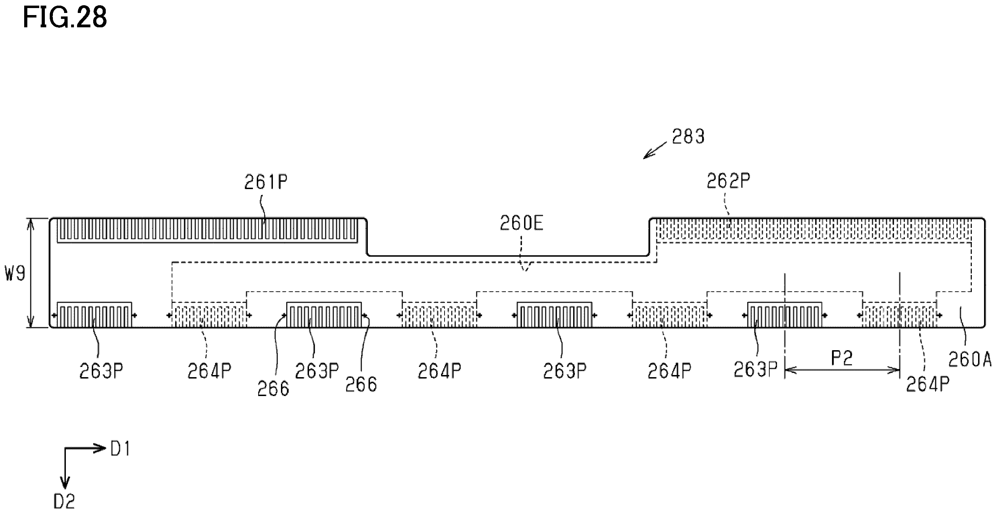

As shown in Fig. 28, in the second conductive layer 260E, the second bonding terminal 262P is disposed on one side in the second direction D2 and the respective second relay terminals 264P are disposed on the other side in the second direction D2. In Fig. 28, the outline of the second conductive layer 260E is indicated by the dotted line. The second conductive layer 260E extends in the second direction D2 from the second bonding terminal 262P to each of the second relay terminals 264P.

The portions of the second conductive layer 260E connecting the second bonding terminal 262P and each of the second relay terminals 264P overlap the portions of the first conductive layer 260D connecting the first bonding terminal 261P and each of the first relay terminals 263P via the inner insulating layer 260C.

According to the above arrangement of the first conductive layer 260D and the second conductive layer 260E, the first relay terminals 263P and the second relay terminals 264P can be disposed on one side of the first flexible wiring board 283 in the second direction D2. In this case, compared with the first flexible wiring board 260 of the third embodiment, the wiring path connecting the second bonding terminal 262P and each of the second relay terminals 264P can be made shorter. As a result, a width W9 of the first flexible wiring board 283 in the second direction D2 can be made smaller than the width W5 of the first flexible wiring board 260.

In the case of the first flexible wiring board 283, a structure such as the through hole 265 for electrically connecting the first conductive layer 260D and the second conductive layer 260E is not necessary. Therefore, the flexibility and bending resistance of the first flexible wiring board 283 can be improved.

As shown in Fig. 29, the second flexible wiring board 290 includes a third outer insulating layer 290A, a fourth outer insulating layer 290B, an inner insulating layer 290C, a third conductive layer 290D and a fourth conductive layer 290E. The inner insulating layer 290C is disposed between the third outer insulating layer 290A and the fourth outer insulating layer 290B. The third outer insulating layer 290A is located on a side of the inner insulating layer 290C facing the first space partitioned by the light control sheet 10 (in Fig. 29, rear side of the paper). The fourth outer insulating layer 290B is located on a side of the inner insulating layer 290C facing the second space partitioned by the light control sheet 10 (in Fig. 29, front side of the paper). The third outer insulating layer 290A, the fourth outer insulating layer 290B and the inner insulating layer 290C are insulating resin films, and may be made of, for example, polyimide.

The third conductive layer 290D is disposed between the third outer insulating layer 290A and the inner insulating layer 290C. The fourth conductive layer 290E is disposed between the fourth outer insulating layer 290B and the inner insulating layer 290C. The third conductive layer 290D and the fourth conductive layer 290E are conductive metal films, and may be made of, for example, copper foil. The second flexible wiring board 290 having a double-sided structure includes the third outer insulating layer 290A, the third conductive layer 290D, the inner insulating layer 290C, the fourth conductive layer 290E and the fourth outer insulating layer 290B laminated in this order.

In the second flexible wiring board 290, the third relay terminal 271P, the first power supply terminal 273P and the second power supply terminal 274P are portions where the fourth conductive layer 290E is exposed from the fourth outer insulating layer 290B to the second space. In the second flexible wiring board 290, the fourth relay terminal 272P is a portion where the third conductive layer 290D is exposed from the third outer insulating layer 290A to the first space. Therefore, the third relay terminal 271P and the fourth relay terminal 272P face opposite directions.

The third relay terminal 271P is electrically connected to the first power supply terminal 273P via the fourth conductive layer 290E inside the second flexible wiring board 290. Further, in the fourth conductive layer 290E, portions constituting the third relay terminal 271P and the first power supply terminal 273P are electrically insulated from a portion constituting the second power supply terminal 274P.

The third conductive layer 290D constituting the fourth relay terminal 272P is electrically connected to a portion of the fourth conductive layer 290E constituting the second power supply terminal 274P via a plurality of through holes 291. Therefore, the fourth relay terminal 272P is electrically connected to the second power supply terminal 274P via the third conductive layer 290D, the fourth conductive layer 290E and the through hole 291 inside the second flexible wiring board 290. The number of through holes 291 may be one or may be two or more.

In the case of the seventh embodiment, the connection of the third relay terminal 271P to one of the first relay terminal 263P and the second relay terminal 264P and the connection of the fourth relay terminal 272P to the other of the first relay terminal 263P and the second relay terminal 264P are performed separately.

### [Advantageous Effects of Seventh Embodiment]

According to the seventh embodiment, the advantageous effects described below can be achieved.
(7-1) In the first flexible wiring board 283, the first bonding terminal 261P and the first relay terminals 263P are formed of the first conductive layer 260D, and the second bonding terminal 262P and the second relay terminals 264P are formed of the second conductive layer 260E. Accordingly, a width W9 of the first flexible wiring board 283 in the second direction D2 can be made smaller than the width W5 of the first flexible wiring board 260. As a result, while the flexible wiring board unit 250 is connected to the light control sheet 10, the length of the first flexible wiring board 283 protruding from the light control sheet 10 can be reduced. Further, the flexible wiring board unit 250 including the first flexible wiring board 283 can also achieve the advantageous effects similar to the above (1-1) and (3-1).
(7-2) In the first flexible wiring board 283, a structure such as the through hole 265 for electrically connecting the first conductive layer 260D and the second conductive layer 260E is not necessary. Therefore, the flexibility and bending resistance of the first flexible wiring board 283 can be improved.

### [Modifications of Third to Seventh Embodiments]

The third to seventh embodiments can be modified and implemented as follows. The modifications described below can be combined with each other as long as no technical contradiction occurs.

- In the third to seventh embodiments, the reference portion 266 and the registration portion 275 may have any shape as long as two relay terminals to be connected can be appropriately positioned based on the arrangement of the registration portion 275 relative to the reference portion 266. Further, if high precision is not required for positioning of the third relay terminal 271P and the fourth relay terminal 272P relative to the first relay terminals 263P and the second relay terminals 264P, the reference portion 266 and the registration portion 275 may not necessarily be provided.
- In the third to seventh embodiments, the pitch P3 from the center of the third relay terminal 271P to the center of the fourth relay terminal 272P may be larger than the pitch P2 at which the first relay terminals 263P and the second relay terminals 264P are arranged. For example, the pitch P3 may be an odd multiple (excluding 1) of the pitch P2. That is, the configuration may be such that when the third relay terminal 271P is electrically connected to one of the first relay terminal 263P and the second relay terminal 264P, the fourth relay terminal 272P is electrically connected to the other of the first relay terminal 263P and the second relay terminal 264P.
- In the third to sixth embodiments, the first power supply terminal 73P and the second power supply terminal 274P of the second flexible wiring board 270 may face opposite directions. In this case, in the second flexible wiring board 270, a through hole is provided between the third relay terminal 271P and the first power supply terminal 273P or between the fourth relay terminal 272P and the second power supply terminal 274P. This increases the degree of freedom in the form of connection of the first power supply terminal 273P and the second power supply terminal 274P to the external power supply 1A.
- In the seventh embodiment, the first power supply terminal 273P and the second power supply terminal 274P of the second flexible wiring board 290 may face opposite directions. For example, the second power supply terminal 274P may be formed of the third conductive layer 290D. In this case, the first power supply terminal 273P face the second space, while the second power supply terminal 274P face the first space. The fourth relay terminal 272P is electrically connected to the second power supply terminal 274P via the third conductive layer 290D inside the second flexible wiring board 290. In this case, in the second flexible wiring board 290, a structure such as the through hole 291 for electrically connecting the third conductive layer 290D and the fourth conductive layer 290E is not necessary. Therefore, the flexibility and bending resistance of the second flexible wiring board 290 can be improved.
- In the third to seventh embodiments, among the plurality of first relay terminals 263P, the first relay terminal 263P that is not connected to the third relay terminal 271P may be covered with the first outer insulating layer 260A by not removing the first outer insulating layer 260A located on the outer surface side. In other words, among the plurality of first relay terminals 263P, at least the first relay terminal 263P that is connected to the third relay terminal 271P may be exposed from the first outer insulating layer 260A. Covering the first relay terminal 263P that is not connected to the third relay terminal 271P with the first outer insulating layer 260A can simplify sealing of the first relay terminal 263P that is not connected to the third relay terminal 271P. The same modification can be applied to the second relay terminal 264P that is not connected to the fourth relay terminal 272P among the plurality of second relay terminals 264P.

### [Modifications of First to Seventh Embodiments]

The first to seventh embodiments can be modified and implemented as follows. The modifications described below can be combined with each other as long as no technical contradiction occurs.

- In the first to seventh embodiments, the first transparent electrode sheet 20 may include other functional layers such as a UV shielding layer, an infrared shielding layer, an alignment layer, an adhesive layer and a protective layer. The second transparent electrode sheet 30 may include other functional layers such as a UV shielding layer, an infrared shielding layer, an alignment layer, an adhesive layer and a protective layer.
- In the first to seventh embodiments, the light control sheet 10 is not limited to a rectangular shape, and may have a geometric shape such as a polygonal shape other than a rectangular shape, a circular shape or an elliptical shape, or an irregular shape other than a geometric shape. The light control sheet 10 is not limited to a two-dimensional flat surface, and may be a curved surface such as a cylindrical, spherical or wavy surface.

## Claims

1. A flexible wiring board unit comprising:
a first flexible wiring board extending in a first direction; and
a second flexible wiring board extending in a second direction, wherein
the second flexible wiring board is configured to be electrically connected to the first flexible wiring board on a first side of the second flexible wiring board in the second direction, the first direction and the second direction mutually intersecting,
the first flexible wiring board includes a first bonding terminal and a second bonding terminal arranged in the first direction,
the first bonding terminal and the second bonding terminal are configured to be connected to a power supply target,
the second flexible wiring board includes a first power supply terminal and a second power supply terminal disposed on a second side which is opposite to the first side in the second direction, and
the first power supply terminal and the second power supply terminal are configured to be connected to an external power supply.

2. The flexible wiring board unit according to claim 1, wherein
the first flexible wiring board includes a first relay terminal configured to be electrically connected to the first bonding terminal inside the first flexible wiring board, and a second relay terminal configured to be electrically connected to the second bonding terminal inside the first flexible wiring board,
the second flexible wiring board includes a third relay terminal and a fourth relay terminal disposed on the first side,
the third relay terminal is electrically connected to the first power supply terminal inside the second flexible wiring board, and the fourth relay terminal is electrically connected to the second power supply terminal inside the second flexible wiring board,
the first flexible wiring board and the second flexible wiring board are formed of a laminate of an insulating layer and a conductive layer,
the second flexible wiring board has fewer layers than the first flexible wiring board does,
in the first flexible wiring board, the first bonding terminal faces a direction opposite to that in which the second bonding terminal, the first relay terminal and the second relay terminal face,
in the second flexible wiring board, the third relay terminal, the fourth relay terminal, the first power supply terminal and the second power supply terminal face the same direction, and
in a plane including the first direction and the second direction, a relative position of the second relay terminal to the first relay terminal is equal to a relative position of the fourth relay terminal to the third relay terminal such that the third relay terminal is electrically connected to the first relay terminal and the fourth relay terminal is electrically connected to the second relay terminal.

3. The flexible wiring board unit according to claim 2, wherein
the second direction is perpendicular to the first direction.

4. The flexible wiring board unit according to claim 3, wherein
the second flexible wiring board is connected to the first flexible wiring board at the center of the first flexible wiring board in the first direction.

5. The flexible wiring board unit according to claim 3, wherein
the second flexible wiring board is connected to the first flexible wiring board at a position displaced toward one side from the center of the first flexible wiring board in the first direction.

6. The flexible wiring board unit according to claim 1, wherein
the first flexible wiring board includes a first relay terminal and a second relay terminal arranged in the second direction,
the first relay terminal includes a plurality of first tooth terminals arranged in the first direction at a predetermined pitch,
the plurality of first tooth terminals are electrically connected to the first bonding terminal inside the first flexible wiring board,
the second relay terminal includes a plurality of second tooth terminals arranged in the first direction at the predetermined pitch,
the plurality of second tooth terminals are electrically connected to the second bonding terminal inside the first flexible wiring board,
the second flexible wiring board includes a third relay terminal and a fourth relay terminal disposed on the first side,
the third relay terminal includes a plurality of third tooth terminals arranged in the first direction at the predetermined pitch,
the plurality of third tooth terminals are electrically connected to the first power supply terminal inside the second flexible wiring board,
the fourth relay terminal includes a plurality of fourth tooth terminals arranged in the first direction at the predetermined pitch,
the plurality of fourth tooth terminals are electrically connected to the second power supply terminal inside the second flexible wiring board,
the number of the first tooth terminals is greater than the number of the third tooth terminals,
the number of the second tooth terminals is greater than the number of the fourth tooth terminals, and
the fourth relay terminal is disposed relative to the third relay terminal such that when each of the third tooth terminals is electrically connected to corresponding one of the plurality of first tooth terminals, each of the fourth tooth terminals is electrically connected to corresponding one of the plurality of second tooth terminals.

7. The flexible wiring board unit according to claim 6, wherein
in the first flexible wiring board, the first relay terminal and the second relay terminal face the same direction, and
in the second flexible wiring board, the third relay terminal and the fourth relay terminal face the same direction.

8. The flexible wiring board unit according to claim 7, wherein
in the first flexible wiring board, the first bonding terminal faces the same direction as the first relay terminal and the second relay terminal face, and the second bonding terminal faces a direction opposite to that in which the first relay terminal and the second relay terminal face, and
in the second flexible wiring board, the first power supply terminal and the second power supply terminal face the same direction as the third relay terminal and the fourth relay terminal face.

9. The flexible wiring board unit according to any one of claims 6 to 8, wherein
among the plurality of third tooth terminals, the third tooth terminal located on each end in the first direction includes a registration portion,
each of the first tooth terminals includes a reference portion, and
when the reference portion of the first tooth terminal to be connected to the third tooth terminal located on each end in the first direction is arranged in an appropriate position relative to the registration portion of the third tooth terminal in each of the first direction and the second direction, the first tooth terminals are arranged in appropriate positions relative to the third tooth terminals.

10. The flexible wiring board unit according to claim 1, wherein
the first flexible wiring board includes a plurality of first relay terminals configured to be electrically connected to the first bonding terminal inside the first flexible wiring board, and a plurality of second relay terminals configured to be electrically connected to the second bonding terminal inside the first flexible wiring board,
the first relay terminals and the second relay terminals are alternately arranged in a row in the first direction at a predetermined pitch,
the second flexible wiring board includes a third relay terminal and a fourth relay terminal disposed on the first side,
the third relay terminal is electrically connected to the first power supply terminal inside the second flexible wiring board, and the fourth relay terminal is electrically connected to the second power supply terminal inside the second flexible wiring board, and
the fourth relay terminal is disposed relative to the third relay terminal such that when the third relay terminal is electrically connected to one of the first relay terminal and the second relay terminal, the fourth relay terminal is electrically connected to the other of the first relay terminal and the second relay terminal.

11. The flexible wiring board unit according to claim 10, wherein
in the first flexible wiring board, the first relay terminal and the second relay terminal face the same direction, and
in the second flexible wiring board, the third relay terminal and the fourth relay terminal face the same direction.

12. The flexible wiring board unit according to claim 11, wherein
in the first flexible wiring board, the first bonding terminal faces the same direction as the first relay terminal and the second relay terminal face, and the second bonding terminal faces a direction opposite to that in which the first relay terminal and the second relay terminal face, and
in the second flexible wiring board, the first power supply terminal and the second power supply terminal face the same direction as the third relay terminal and the fourth relay terminal face.

13. The flexible wiring board unit according to claim 10, wherein
in the first flexible wiring board, the first relay terminal and the second relay terminal face opposite directions, the first bonding terminal faces the same direction as the first relay terminal faces, and the second bonding terminal faces the same direction as the second relay terminal faces, and
in the second flexible wiring board, the third relay terminal and the fourth relay terminal face opposite directions.

14. A light control unit comprising:
a light control sheet having an edge extending in a first direction; and
a flexible wiring board unit bonded to the edge, wherein
the light control sheet includes:
a first transparent electrode sheet;
a second transparent electrode sheet; and
a light control layer disposed between the first transparent electrode sheet and the second transparent electrode sheet,
a portion of the first transparent electrode sheet exposed from the light control layer and the second transparent electrode sheet is a first electrode terminal,
a portion of the second transparent electrode sheet exposed from the light control layer and the first transparent electrode sheet is a second electrode terminal,
the first electrode terminal and the second electrode terminal are arranged in the first direction at the edge,
the flexible wiring board unit includes:
a first flexible wiring board extending in the first direction; and
a second flexible wiring board extending in the second direction,
the second flexible wiring board is configured to be electrically connected to the first flexible wiring board on a first side of the second flexible wiring board in the second direction, the first direction and the second direction mutually intersecting,
the first flexible wiring board includes a first bonding terminal and a second bonding terminal arranged in the first direction,
the first bonding terminal is configured to be electrically connected to the first electrode terminal,
the second bonding terminal is configured to be electrically connected to the second electrode terminal,
the second flexible wiring board includes a first power supply terminal and a second power supply terminal disposed on a second side which is opposite to the first side in the second direction, and
the first power supply terminal and the second power supply terminal are configured to be connected to an external power supply.

15. The light control unit according to claim 14, wherein
the first flexible wiring board includes a first relay terminal configured to be electrically connected to the first bonding terminal inside the first flexible wiring board, and a second relay terminal configured to be electrically connected to the second bonding terminal inside the first flexible wiring board,
the second flexible wiring board includes a third relay terminal and a fourth relay terminal disposed on the first side,
the third relay terminal is electrically connected to the first power supply terminal inside the second flexible wiring board, and the fourth relay terminal is electrically connected to the second power supply terminal inside the second flexible wiring board,
the first flexible wiring board and the second flexible wiring board are formed of a laminate of an insulating layer and a conductive layer,
the second flexible wiring board has fewer layers than the first flexible wiring board does, in the first flexible wiring board, the first bonding terminal faces a direction opposite to that in which the second bonding terminal, the first relay terminal and the second relay terminal face,
in the second flexible wiring board, the third relay terminal, the fourth relay terminal, the first power supply terminal and the second power supply terminal face the same direction, and
in a plane including the first direction and the second direction, a relative position of the second relay terminal to the first relay terminal is equal to a relative position of the fourth relay terminal to the third relay terminal such that the third relay terminal is electrically connected to the first relay terminal and the fourth relay terminal is electrically connected to the second relay terminal.

16. The light control unit according to claim 14, wherein
the first flexible wiring board includes a first relay terminal and a second relay terminal arranged in the second direction,
the first relay terminal includes a plurality of first tooth terminals arranged in the first direction at a predetermined pitch,
the plurality of first tooth terminals are electrically connected to the first bonding terminal inside the first flexible wiring board,
the second relay terminal includes a plurality of second tooth terminals arranged in the first direction at the predetermined pitch,
the plurality of second tooth terminals are electrically connected to the second bonding terminal inside the first flexible wiring board,
the second flexible wiring board includes a third relay terminal and a fourth relay terminal disposed on the first side,
the third relay terminal includes a plurality of third tooth terminals arranged in the first direction at the predetermined pitch,
the plurality of third tooth terminals are electrically connected to the first power supply terminal inside the second flexible wiring board,
the fourth relay terminal includes a plurality of fourth tooth terminals arranged in the first direction at the predetermined pitch,
the plurality of fourth tooth terminals are electrically connected to the second power supply terminal inside the second flexible wiring board,
the number of the first tooth terminals is greater than the number of the third tooth terminals,
the number of the second tooth terminals is greater than the number of the fourth tooth terminals, and
when each of the third tooth terminals is electrically connected to corresponding one of the plurality of first tooth terminals, each of the fourth tooth terminals is electrically connected to corresponding one of the plurality of second tooth terminals.

17. The light control unit according to claim 14, wherein
the first flexible wiring board includes a plurality of first relay terminals configured to be electrically connected to the first bonding terminal inside the first flexible wiring board, and a plurality of second relay terminals configured to be electrically connected to the second bonding terminal inside the first flexible wiring board,
the first relay terminals and the second relay terminals are alternately arranged in a row in the first direction at a predetermined pitch,
the second flexible wiring board includes a third relay terminal and a fourth relay terminal disposed on one side in the second direction,
the third relay terminal is electrically connected to the first power supply terminal inside the second flexible wiring board, and the fourth relay terminal is electrically connected to the second power supply terminal inside the second flexible wiring board, and
the third relay terminal is electrically connected to one of the first relay terminal and the second relay terminal, and the fourth relay terminal is electrically connected to the other of the first relay terminal and the second relay terminal.
